# EUROPEAN PATENT SPECIFICATION

(11) **EP 2 589 073 B1**
(45) Date of publication and mention of the grant of the patent: **23.09.2015**
(21) Application number: 11743023.1
(22) Date of filing: 29.06.2011
(51) Int. Cl.: H01L 21/68, B25J 9/16

(54) **METHOD AND APPARATUS FOR CALIBRATING A WAFER TRANSPORT ROBOT**
VERFAHREN UND VORRICHTUNG ZUR KALIBRIERUNG EINES WAFERTRANSPORTROBOTERS
PROCÉDÉ ET APPAREIL POUR ÉTALONNER UN ROBOT DE TRANSPORT DE TRANCHES

(30) Priority: 29.06.2010 DE 102010025483
(43) Date of publication of application: 08.05.2013
(73) Proprietor: centrotherm photovoltaics AG, 89143 Blaubeuren (DE)
(72) Inventor: KNÖPFLE, Daniel, 89155 Ringingen (DE); HARTMANN, Andreas, 89604 Allmendingen (DE); GRAF, Ottmar, 88368 Bergatreute (DE)
(74) Representative: Wimmer, Hubert
(86) International application number: PCT/EP2011/003202
(87) International publication number: WO 2012/000663

(56) References cited:
- US-A1- 2005 102 064

## Description

The present invention relates to a method and an apparatus for calibrating a wafer transport robot provided for loading wafers into a wafer boat. The wafer transport robot is particularly provided for one type of wafer boat, which consists of a plurality of plates arranged generally parallel to each other and opposing each other, and wherein a plurality of receptacles for receiving the wafers is provided between adjacently arranged plates. The wafer transport robot comprises a wafer gripper adapted for inserting a wafer in the receptacle between the plates and for removing the wafer therefrom. The invention is directed to a method and an apparatus for loading and/or unloading a wafer boat of the above type via a wafer transport robot.

In the art of semiconductors and solar cells, it is known to subject disk-shaped substrates made from different materials, which are referred to as wafers in the following, to different processes.

In doing so, wafers are often subjected to individual processing as well as batch processing, i.e. processes in which several wafers are processed at the same time. For individual processing as well as for batch processing, wafers need to be transferred to a desired processing position. In batch processing, this is usually done by inserting wafers in so-called boats, which comprise receptacles for a plurality of wafers. In the boats, the wafers are usually arranged parallel to each other. Such boats may be constructed in different ways, and often these boats provide for holding of the lower edges of each wafer only in such a way that the wafers are standing with the upper part free. Such boats may comprise e.g. inserting chamfers for facilitating insertion of the respective lower edges of the wafers into the boats.

With the type of wafer boat mentioned above, which is used e.g. for plasma nitriding of wafers in the art of solar cells, the wafer boat is formed by a plurality of electrically conductive plates which are usually made of graphite. The plates are arranged substantially parallel to each other, and receiving slots for receiving wafers are formed between adjacent plates. The sides of the plates facing each other each comprise corresponding holding elements for wafers such that a wafer may be held at each side of the plate comprising corresponding receiving elements. In this way, two wafers may be received entirely between the plates in each receiving slot. Adjacent plates of the wafer boat are electrically isolated and may be biased with different biasing voltages during the process. By this means, it is possible to form a plasma between the substrates held at each of the plates, in order to provide for plasma processing of the substrates, such as plasma nitriding.

High precision is required for loading/unloading of such a boat, since the wafers need to be guided parallely and closely spaced to the corresponding plate element during loading and unloading over a comparatively large lifting distance. In order to facilitate such guiding, as is well-known in the art, boats may be mechanically clamped in a defined position during loading/unloading and a wafer transport robot may be manually taught this position, or, as is also well-known in the art, specially trained persons may perform the loading/unloading. The quality of the loading process depends, on the one hand, on the accuracy of the wafer boat and, on the other hand, on the experience and the skills of the operator.

Furthermore, a problem exists in the fact that, during continuous operation, a plurality of boats advance through the process facility, wherein each of these boats may be distorted or deformed in a different way. The reason for this might be e.g. thermal stress or imprecise mounting or assembly of the boats. Therefore, a wafer transport robot would need to be trained for each of the single boats individually before each process, which is laborsome and expensive.

Furthermore, the positions of the plate with respect to each other may change over time, e.g. due to loosening of clamping or chucking elements. From this fact, the problem arises that plates are not necessarily located in a precisely known position even if the boats are arranged in a determined initial position. In this case, the wafers cannot be loaded/unloaded sufficiently precise during loading and/or unloading via a wafer transport robot. Thus, damages to the substrates and/or the wafer boat may occur.

Furthermore, the wafer boats should not be chucked, if possible, in order to avoid the results of mechanical and especially thermal stresses. Without chucking or clamping, however, further inaccuracy during positioning of the wafer boats may occur.

In document DE 10 2010 018 465 A, which belongs to the same applicant and was not published before the filing of this application, a sensor array and a method for measuring the spatial arrangement of plates of a wafer boat of the type mentioned above is described, which is provided for alleviating the problems mentioned above. With respect to the construction of the sensor array and with respect to measuring the spatial arrangement of plates of a wafer boat, this document is referred to, in order to avoid redundancies.

Wafer transport robots used for such loading/unloading of a wafer boat, usually have a pedestal or base, a wafer gripper, and a plurality of elements which are movable with respect to each other, especially arms connected via joints or axes, wherein the wafer gripper is connected to the base via these elements or arms and may be moved with respect to the base. Furthermore, such wafer transport robots usually have an internal coordinate system, which has an origin or fixed point at a well-defined position with respect to the robot (e.g. in the pedestal or base of the robot). Also, additional coordinate systems may be programmed into the wafer transport robot in such a way that a reference between each of the coordinate systems and the coordinate system of the wafer transport robot is determined. However, such an approach is very complicated.

Starting from this coordinate system, the wafer transport robot may move the wafer gripper to certain points in the coordinate system via the elements movable with respect to each other, wherein usually a certain point of the wafer gripper, such as the central point thereof, is moved to a certain coordinate.

Wafer transport robots of the type mentioned above, usually comprise high resolution encoders connected to the movable elements thereof, especially at their joints or axes, and thus, these wafer robots may move to positions in a very precise manner. In this regard, absolute precision and repetitive precision have to be distinguished. The precision with which the wafer transport robot can move the wafer gripper (specifically the central point thereof) to a predefined position in the coordinate system is refereed to as absolute precision. On the contrary, the precision between repetitive movements of the wafer gripper in the same position is referred to as repetitive precision. Due to the encoders having high resolution and due to consistent kinematics and mechanics, the repetitive precision of the wafer transport robot during unvarying operation is much better than the absolute precision. The absolute precision of the wafer transport robot results from tolerances of the mechanical components and transmissions thereof, which comprise a certain backlash or clearance.

One possibility for improving the absolute preciseness is to measure a wafer transport robot within its working space and, if necessary, to store measured offsets in the robot control unit in order to compensate said offsets during operation. However, such measuring of a wafer transport robot is a complex process and, therefore, is very expensive.

US 2005 102 064 A1 relates to a method and apparatus for self-calibration of a substrate handling robot. The substrate-handling robot which serves a processing tool may be automatically controlled by a controller to perform a self-calibration procedure. As part of the procedure, an end effector of the robot is moved to interact with sensors provided on a calibration fixture that is positioned in a substrate placement location for which the calibration procedure is performed. The calibration fixture may have an opening formed therein to allow movement of the robot end effector within the calibration fixture. Sensor light beams generated by the sensors may interact with the end effector during the automatic calibration process so as to determine calibration data for the substrate placement location.

A problem to be solved by the present invention is to provide a method for calibrating a wafer transport robot in order to ensure proper loading/unloading of a wafer boat in a simple manner. A further problem to be solved by the invention is to provide a method and an apparatus for loading/unloading a wafer boat.

According to the invention, a method for calibrating a wafer transport robot according to claims 1 and 3, respectively, and a method and an apparatus for loading/unloading a wafer boat according to claims 4 and 9, respectively, are provided. The dependent claims relate to further embodiments of the invention.

Particularly, a method for calibrating a wafer transport robot for loading wafers into a wafer boat is provided, wherein the wafer boat is made of a plurality of plates, which are generally arranged parallel to each in an opposing manner, and wherein the wafer boat comprises a plurality of receptacles for receiving the wafers, the receptacles being arranged between adjacently located plates, and wherein the wafer transport robot comprises a wafer gripper which is adapted to insert a wafer into the receptacles between the plates and for removing the wafers therefrom. For calibrating, the wafer gripper is initially moved to a first position, which approximately corresponds to a theoretical loading position of the wafer boat. This theoretical loading position is e.g. a position in which the wafer gripper would hand over a wafer to a receptacle of an ideal (not distorted) wafer boat, which is positioned in known manner, wherein indeed no wafer boat is present at a loading position. In this position, the spatial position or location of the wafer gripper is determined by moving at least three sensors along predetermined movement paths perpendicular to the wafer gripper, wherein, during the movement, each of the sensors is directed to an edge region of the wafer gripper or to the edge region of a plate element supported by the wafer gripper in known manner. The positions of the sensors along the corresponding movement paths are determined and positions are detected, in which a corresponding edge region comes into the measuring range of a corresponding sensor and exits from the measuring range. Furthermore, a distance between each of the sensors and the corresponding edge region is measured. An edge region in this context is meant to be the region of an edge of the wafer gripper or of a plate element supported by the wafer gripper in known manner, which comes into the field of view of the corresponding sensors during movement. Afterwards, at least one correction or compensation parameter for positioning the wafer gripper is determined based on a difference between a determined spatial position of the wafer gripper and the theoretical loading position. Thereafter, the operation may be repeated for additional theoretical loading positions. The above mentioned method allows for automatically measuring the wafer gripper in theoretical loading positions and the determination of compensation parameters in a simple way in order to allow for precise positioning of the wafer gripper during an actual loading/unloading operation of the wafers. Especially, the absolute precision of the wafer transport robot may be improved for the loading/unloading of wafers.

Preferably, the wafer gripper is moved to a new position after determining the at least one compensation parameter while taking into account the at least one compensation parameter, wherein the new position corresponds again approximately to the theoretical loading position of the wafer boat, and thereafter the spatial position of the wafer gripper is determined a second time, and from this determination, at least one new compensation parameter is determined. This operation may be repeated one time or several times, in case the difference between the determined spatial position of the wafer gripper and the theoretical loading position is not within a predetermined tolerance. Thus, calibration may be checked and corrected as long as positioning of the wafer gripper within predetermined tolerances is facilitated.

In an alternative method for calibrating a wafer transport robot for loading a wafer boat of the above mentioned type, which wafer transport robot comprises a plurality of elements, especially joints and axes which are movable which respect to each other, and which also comprise a wafer gripper at one end, a predetermined point of the wafer gripper e.g. the central point thereof, is moved to a first position within a theoretical loading zone for a wafer boat using a robot coordinate system. A theoretical loading zone in this context means a zone in which, during normal operation of the wafer transport robot, the loading/unloading positions of a wafer boat may be anticipated. This zone is determined by the size of the wafer boat and the maximum positional deviations thereof. The position may be chosen arbitrarily within the zone; however, the position may also correspond to a theoretical loading/unloading position, as was mentioned above. Afterwards, the spatial position of the wafer gripper is automatically determined by moving at least three sensors along predetermined movement paths across the wafer gripper, wherein the sensors are directed to an edge region of the wafer gripper or to the edge region of a plate element supported by the wafer gripper in a known manner during the movement. During this operation, the position of the sensors along the corresponding movement paths is determined, the positions in which a corresponding edge region comes into the measuring region of a corresponding sensor or exits from the measuring region are detected, and the distance between the respective sensor and the respective edge region is measured. Thereafter, the wafer gripper is moved to different orientations by use of the robot coordinate system, while the predetermined point of the wafer gripper stays in the first position. Particularly, the wafer gripper may be rotated about different axes, each passing through the first point. In each of these different orientations, the spatial position of the wafer gripper is determined in the manner described above. The predetermined point of the wafer gripper is moved to at least one further position within the theoretical loading zone of the wafer boat by use of the robot coordinate system, and the spatial position of the wafer gripper is determined again for different orientations at this position and possible further positions. The corresponding coordinate data of the robot coordinate system are stored in relation to the corresponding determined spatial position of the wafer gripper.

Such a method allows for spanning a theoretical space from the data wherein in the theoretical space each possible position and orientation of the wafer gripper may be specifically approached by use of the robot coordinate system. Intermediate positions, i.e. positions located between actually measured positions, may be approached e.g. by interpolation of data between actually measured positions. By this means, the absolute precision of the wafer transport robot for the loading/unloading of wafers may be improved in a simple manner. It will be obvious to the person skilled in the art that the accuracy of the method increases with an increasing number of measuring positions.

During the method for loading and/or unloading of a wafer boat of the type described above, a wafer transport robot is initially calibrated as described above. Thereafter, the spatial position of the plates of the wafer boat are determined for a corresponding loading or unloading operation by use of the at least three sensors, which were used for calibrating the wafer transport robot, and the spatial position of the plates determined in this way is relayed to the wafer transport robot. The wafer transport robot controls its wafer gripper according to the positional information in order to load and/or unload the wafer boat. During this method, the same array of sensors is used for calibrating the wafer transport robot as well as for determining the position of the plates of a wafer boat. Therefore a very high precision may be achieved during loading/unloading of the wafer boat. It is not necessary to determine the exact spatial position of the wafer grippers and the plates, but only the spatial position relative to the sensor array.

The spatial position of the plates may be determined by moving the at least three sensors along the predetermined movement path across the plates, wherein at least a first movement path is located above the wafer boat, wherein a second movement path is located below the wafer boat, and wherein a third movement path is located laterally spaced with respect to the first or second movement path above or below the wafer boat, and wherein the sensors are directed to the edge region of the plates during the movement. During the movement, the positions of the sensors along the respective movement path are continuously determined, the position, in which a respective edge region of the plates comes into the measurement region of one of the sensors and exits from this measurement region is determined, and the distance between each sensor and the corresponding edge region of the plates is measured. By this means, the spatial position of the plates, and thus the spatial position of the receptacles of the wafer boat for loading/unloading, may be determined with good precision in a simple manner.

In the above mentioned methods, each of the sensors may be moved along the predetermined movement path across at least one reference plate During this movement it is measured in which position the sensors detect entering of respective reference edges of the at least one reference plate into the measurement region of the sensors and exiting of the respective reference edges out of the measurement region of the sensors along the movement path. Furthermore the distance between a respective sensor and the corresponding reference edge of the corresponding reference plate is measured. By this means, the sensor array may calibrate itself and may compensate e.g. changes in the sensors or in the support and movement unit for the sensors.

In the above mentioned methods, preferably, at least two of the sensors detect respective edge regions and/or reference edge regions, respectively, during the movement of the sensors, which edge regions are arranged parallel to each other, and at least one sensor detects an inclined edge region and/or reference edge region, which is inclined in a known manner. By detecting two parallel edge regions as well as one edge region inclined thereto in a known manner, the spatial position of the element to be detected may be derived in a simple way. In the above methods, each of the sensors is preferably moved by a common drive mechanism.

The apparatus for loading and/or unloading a wafer boat or the above mentioned type comprises a wafer transport robot having a wafer gripper and a plurality of arms and joints/axes for positioning the wafer gripper. The apparatus comprises a sensor array having at least three sensors, wherein each of the sensors is adapted to measure along a measuring direction the distance between the sensor and an edge region of an element which comes into the measuring range of the sensor. The apparatus further comprises at least one support and drive unit for supporting and driving the sensor along predetermined movement paths and at least one unit for determining the position of the sensors along the movement paths, respectively. Furthermore, at least one control unit for controlling the movement of the wafer transport robot and the sensor array is provided, wherein the control unit is adapted to control the sensor array during a calibrating process as descried above in such a way that the sensor array may determine the spatial position of the wafer gripper within a loading and/or unloading zone and wherein the control unit is adapted to control the movement of the wafer transport robot during loading and/or unloading based on the determined spatial position. Thus, the apparatus allows for calibrating the wafer transport robot for loading and/or unloading of the wafer boat.

Preferably, the wafer gripper is a gripper having a flat plate shape, which may be directly measured by the above mentioned sensor array. Alternatively, the wafer gripper may also be formed in such a way that the wafer gripper may grip a plate element having known dimensions in a predetermined manner, and wherein the edges of the plate element may be measured by the sensor array in order to be able to determine the spatial position of the wafer gripper. The plate element may have a similar shape to the shape of a segment of the plate of the wafer boat. For gripping such a plate element with the wafer gripper in a defined manner, the plate element and/or the wafer gripper may comprise certain orientation structures.

The controller may further be adapted to control the sensor array in such a way that the sensor array determines the spatial position of at least one plate of the wafer boat prior to the respective loading and/or unloading operation. In the following, the controller may control movement of the wafer transport robot based on the determined spatial position of the wafer boat. The positional information of the at least one plate may be used for loading/unloading a receptacle at this plate directly after it has been determined. Alternatively, determining the position of a plurality of plates may be carried out sequentially, and loading/unloading of the receptacles may be carried out thereafter.

In one embodiment of the invention, a reference plate is provided, the reference plate being arranged adjacent to a loading and/or unloading zone for the wafer boat and generally perpendicular to the predetermined movement paths of the sensors. In this case, the sensor device is also adapted for moving the sensor array across the reference plate prior to determining the spatial position of the wafer gripper and/or the at least one plate of the wafer boat in order to carry out a reference measurement for the sensor array. By this means, calibration of the sensor array it self is facilitated.

During movement of the sensor array along the predetermined movement paths, preferably at least two of the sensors are directed to corresponding edge regions of the element to be measured, wherein the edge regions are arranged parallel to each other, and at least one sensor is directed to an oblique or chamfered edge region of the element to be detected. By this means, the spatial position of the element to be detected may be well-achieved in a simple manner. Preferably, the respective movement paths of the sensors are arranged generally perpendicular to the element to be detected.

The invention is described in more detail in the following, referring to the figures; in the figures:
- Figure 1: is a schematic side view of an apparatus for loading/unloading a wafer boat;
- Figure 2: is a perspective view of the wafer boat used in the apparatus according to Figure 1;
- Figure 3: is a schematic top view of the wafer boat according to Figure 2;
- Figure 4: is a schematic perspective view of an inventive sensor array for measuring the spatial position of a plate-like element;
- Figure 5: is a schematic perspective view of the sensor array according to Figure 4 while determining the spatial position of a wafer gripper of a wafer transport robot according to Figure 1;
- Figure 6: is a schematic perspective view of the sensor array according to Figure 4 while determining the spatial position of an alternative wafer gripper;
- Figure 7: is a schematic perspective view of the sensor array according to Figure 4 while measuring a wafer boat according to Figure 1;
- Figure 8: is a schematic perspective view of the sensor array according to Figure 4 while measuring a wafer boat, wherein additionally a reference plate is used;
- Figures 9A-C: are schematic front views of the sensor array according to Figure 4 while measuring different segments of a wafer boat according to Figure 1;
- Figure 10A: is an example of an output signal of a sensor of the sensor array with respect to a position signal; and Figure 10B is an enlarged partial area of the sensor signal according to Figure 10A; and
- Figure 11A: is a schematic view of the sensor array according to Figure 4 while determining the spatial position of a plate element; and Figure 11B is an enlarged, detailed view of a sensor signal of the sensor array according to Figure 11A.

Terms such as top, bottom, left, and right used in the specification are related to the positions in the figures, and these terms should not be regarded as limiting. However, these terms may describe preferred embodiments. The term in general, when used for parallel and perpendicular arrangements or with respect to angles, shall comprise deviations of not more than to ± 3°, preferably not more than ± 2°.

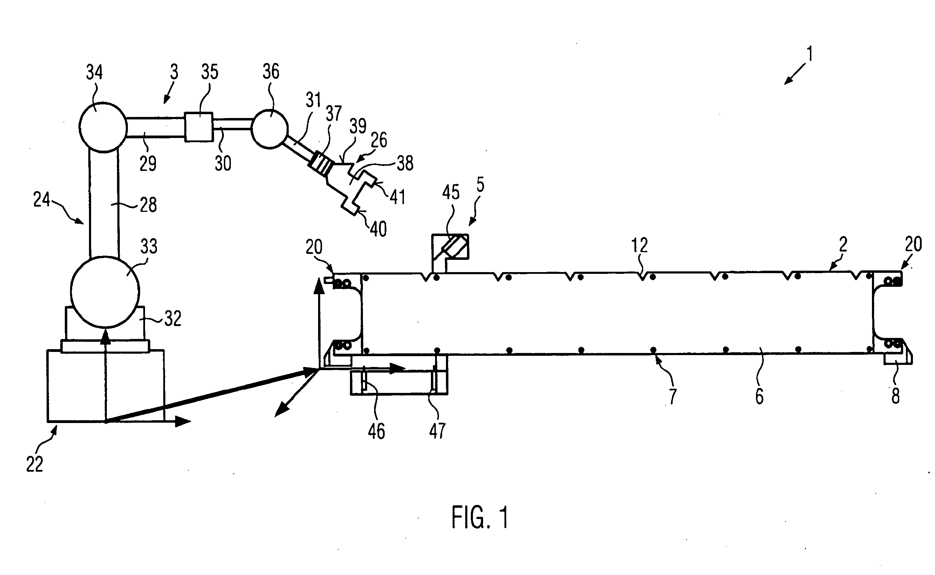

Figure 1 shows a schematic side view of an apparatus 1 for loading/unloading a special wafer boat 2. The apparatus 1 comprises a wafer transport robot 3, a measuring system 5, and a controller or control unit (not shown in detail) for controlling the wafer transport robot and the measuring system.

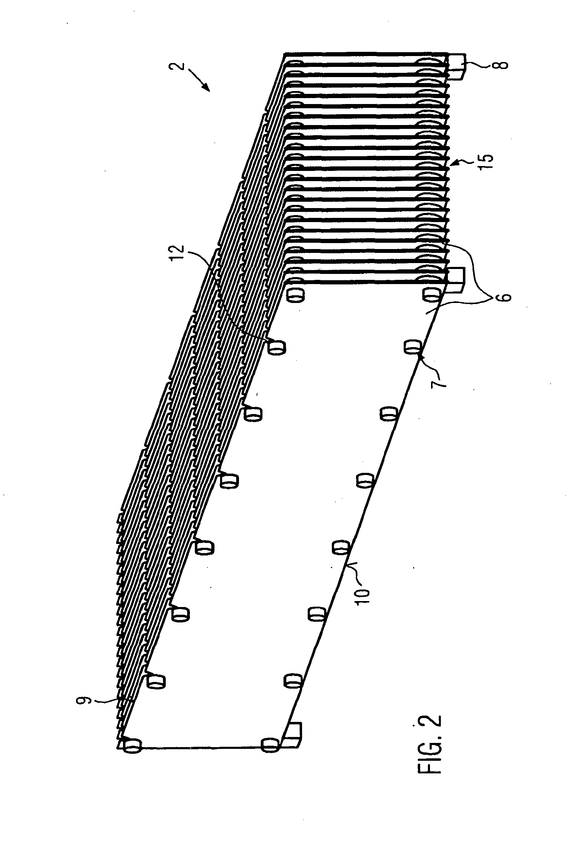

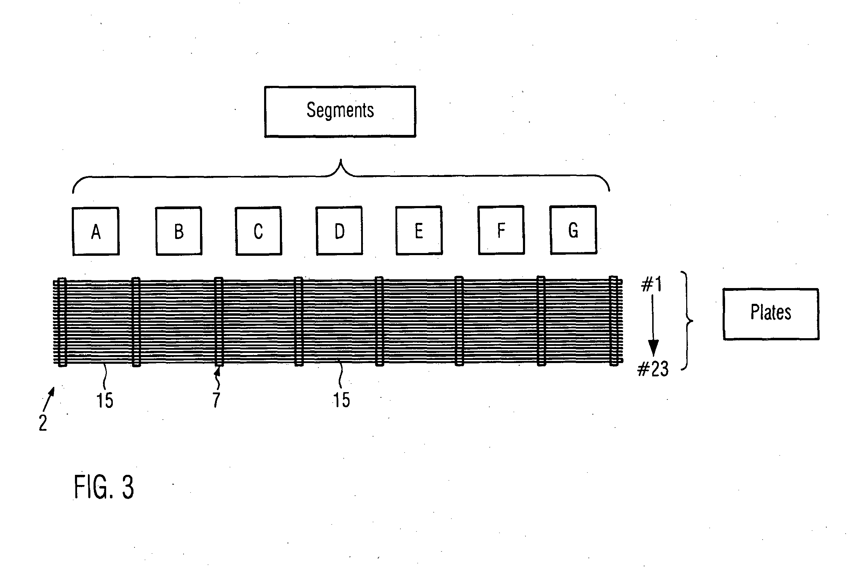

The wafer boat 2 used in the apparatus 1 will be discussed with reference to Figures 2 and 3, which show a perspective view and a schematic top view of the wafer boat 2, respectively.

The wafer boat 2 is formed by a plurality of plates 6, a plurality of clamping or chucking and isolating units 7 and support feet 8. The shown wafer boat 2 is especially adapted for plasma treatment and specifically for plasma nitriding of wafers.

Each of the plates 6 is formed of an electrically conductive material and especially the plates are formed as graphite plates. Each of the plates 6 has a parallel top edge 9 and a bottom edge 10, respectively. In the top edge 9, a plurality of V-formed grooves 12 is formed. In the shown embodiment, each of the plates 6 has seven of these V-formed grooves 12. Each of the grooves 12 has a chamfer with respect to the upper surface, the chamfer generally being arranged at an angle of 45°, wherein also other angles may be provided.

In the shown embodiment, a total of twenty-three plates 6 are provided, the plates 6 being arranged substantially parallel to each other via corresponding clamping and isolating units 7, in order to form receiving or receptacle slits 15 therebetween. If twenty-three plates 6 are provided, twenty-two receptacle slots 15 are formed.

The plates 6 comprise grooves of guiding elements (not shown) on a side facing an adjacent plate 6, the guiding elements having e.g. the form of three pins, which are provided for receiving wafers. In this arrangement, a total of seven groups of guiding elements (corresponding to the number of grooves 12) are arranged in the longitudinal direction of the plate elements, the guiding elements being provided for receiving a semiconductor wafer, as will be discussed in the following in more detail. Thus, it is possible to position seven adjacent wafer pairs in each of the receptacle slots 15.

The chuck and isolating units 7 generally consist of a bolt, spacers, and a nut each. The bolt and the spacers are made from an electrically isolating material. The nut may also be formed from an electrically isolating material, which is not necessary, however. The bolts as well as the spacers may be made e.g. from ceramic. Each of the spacers has preferably the same thickness, in order to arrange the plate elements parallel to each other.

The bolt is sized in such a way that it may protrude through corresponding openings of the plates 6 as well as through corresponding spacers arranged between the plates 6. The plates 6 may be chucked or clamped via the nut. In this case, also other chuck and isolating units are conceivable, which arrange the plates 6 generally parallel to each other in the above-mentioned manner.

A total of sixteen of the chuck and isolating units 7 are provided, wherein eight units are provided adjacent to the top edge 9 of the plates 6 and wherein eight units are arranged adjacent to the bottom edge 10 of the plates 6. The chuck and isolating units 7 are equally distanced and divide the plates 6 into seven segments A-G in the longitudinal direction, each segment A-G corresponding to a group of guiding elements and grooves 12. The grooves 12 in the top edge 9 are located in an edge region of a corresponding segment A-G formed in this way. The segments A-G formed in this way are also aligned with groups of guiding elements on the corresponding plates 6.

The twenty-two receptacle slots 15 between the twenty-three plates 6 as well as their segmentation into seven segments A-G along their longitudinal direction may best be seen in the top view according to Figure 3.

In the view according to Figure 1, also contact elements 20 at the wafer boat 2 may be perceived, the contact elements 20 being provided for electrically contacting the ends of the plates 6. The contact elements 20 are isolated with respect to each other, even though this is not shown in detail, and it is thus possible that adjacent plate elements are biased with inverse bias voltage, as is required for producing a plasma in the receptacle slots 15.

The wafer transport robot 3 has a stationary pedestal or base 22, a drive unit 24, as well as a wafer gripper 26. The base 22 forms a firm base for the wafer transport robot 3 and especially for the drive unit 24.

The drive unit 24 is formed by a plurality of arms 28 to 31 and a plurality of rotational joints 32 to 37, as is known in the art. One end of the drive unit 24 is connected to the base 22, while the other end supports the wafer gripper 26. Especially, a first rotational joint 32 of the drive unit 24 is connected to the base 22. The first rotational joint 32 is rotatable about a first axis perpendicular to the upper surface of the base 22. The first rotational joint 32 supports a second rotational joint 33 on the side not facing the base 22. The second rotational joint is rotatable about a second axis positioned perpendicular to the first axis. One end of a first arm 28 is connected to the second rotational joint 33. The first arm 28 may be arranged in an arbitrary rotational position and in an arbitrary angle with respect to the upper surface of the base via the first and second rotational joints 32, 33. The angle may be varied between 90° and about 0°.

A third rotational joint 34 is provided at the other end of the first arm 28. The third rotational joint 34 is rotatable about a third axis, which is parallel to the second axis. The third rotational joint 34 is connected to one end of a second arm 29. The third rotational joint 34 supports the second arm in such a way that the angle between the first arm 28 and the second arm 29 may be adjusted.

The other end of the second arm 29 is connected to a fourth rotational joint 35. The fourth rotational joint 35 is rotatable about a fourth axis which is perpendicular to the third axis and thus parallel to a longitudinal axis of the second arm 29. The fourth rotational joint 35 supports one end of a third arm 30. The rotational orientation of the third arm may be adjusted in relation to the second arm 29 via the fourth rotational joint 36.

The other end of the third arm 30 supports a fifth rotational joint 36. The fifth rotational joint 36 is rotatable about a fifth axis which is arranged perpendicularly to the fourth axis. The fifth rotational joint 36 supports one end of a fourth arm 31 in such a way that the angle between the fourth arm 31 and the third arm 30 may be adjusted.

The other end of the fourth arm supports a sixth rotational joint 37, which is rotatable about a sixth axis perpendicular to the fifth axis. The sixth rotational joint 37 supports the wafer gripper 26 on the side opposite the fourth arm 31. Thus, the sixth rotational joint 37 is able to adjust the rotational position of the wafer gripper 26 with respect to the fourth arm 31.

Encoders are provided in the region of each rotational joint 32-37, the encoders being able to measure the rotational position of each rotational joint and to transmit the rotational position to a controller (not shown). The controller is adapted to control the movement of the rotational joints 32-37 in order to position the wafer gripper 26 in a desired position and orientation, as is known in the art. To this end, the controller usually starts from a coordinate system of the wafer transport robot 3, which has a fixed reference point (especially a point of origin) e.g. in the base 22. It is obvious that also another coordinate system may be the basis, the other coordinate system having a fixed reference system outside the base. Such wafer transport robots, generally known per se, have an excellent repetition precision, but only have limited absolute precision as long as these wafer transport robots are not calibrated.

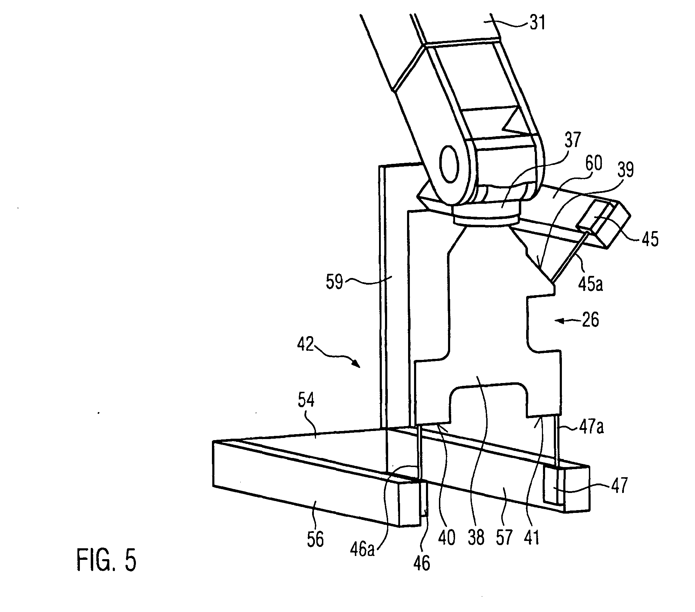

The wafer gripper 26 is a gripper of the plate type having a support plate 38 and at least one vacuum suction device (not shown) for sucking a wafer to the support plate 38. In the embodiment shown in Figure 1 and also in Figure 5, the support plate 38 comprises a first edge region 39 adjacent to the connection to the sixth rotational joint 37. The support plate 38 comprises two spaced second edge regions 40 and 41, which are parallel to each other and are arranged in one plane at the end opposite to the sixth rotational joint 37. These edge regions may be formed by a straight bottom edge of the wafer gripper or by a contoured bottom edge, as is shown. The first edge region extends at an incline with respect to the second edge regions 40, 41, especially inclined at an angle of 45°, wherein also other angles may be provided. In any event, the inclination, i.e. the angle, is known.

The wafer transport robot 3 described above is only an example, and it should be noted that also other wafer transport robots may be employed, which comprise e.g. a different drive unit for positioning a wafer gripper in a desired position and orientation. One example is a drive unit which provides for positioning in two dimensions via rays, which are perpendicularly oriented with respect to each other (usually in a horizontal direction) and which provides for positioning in a third dimension (usually in a vertical direction) via a lifting device extending perpendicularly to the rays. Additionally, a rotation tilt joint may be provided between the lifting device and the wafer gripper for orienting said wafer gripper in such a drive unit.

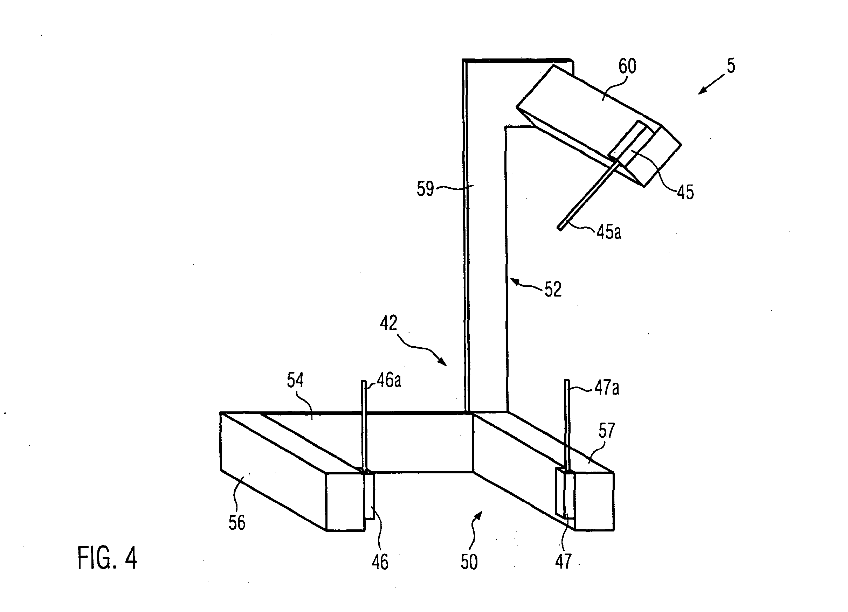

Figure 4 shows a schematic perspective view of the measuring system 5 according to Figure 1. The measuring system 5 is provided, on the one hand for measuring the spatial position of single plates 6 of the wafer boat 2, which was described above referring to Figures 2 and 3 and, on the other hand, for measuring the spatial position of a wafer gripper of the wafer transport robot 3, which will be explained in more detail in the following. As indicated schematically in Figure 1, the measuring system comprises a coordinate system having an origin or reference point in the area of a wafer boat.

The measuring system 5 generally consists of a support element 42, a drive unit (not shown) therefore, as well as three sensors 45, 46, and 47, as well as an analyzing unit (not shown) for the sensor signals of the sensors. The drive unit for the support element 42 is a unit adapted for moving the support element 42 along a predetermined movement path. Alternatively, it is possible to provide a drive unit for the sensors 45, 46, and 47 in order to move these sensors along the support element 42.

The support element 42 consists of a base element 50 as well as an auxiliary element 52. The base element 50 has a generally horizontal U-form, having a bottom wall 54 and two side legs 56, 57, extending perpendicular thereto. The side legs 56, 57 extend generally parallel with respect to each other. On the insides of the side legs 56, 57, sensors 46, 47 are attached to the free ends, respectively.

The auxiliary element 52 generally consists of a first L-shaped leg element 59 and a second leg element 60. The first leg element 59 is connected to the bottom wall 54 at one end in the area of the side leg 57 or may be formed in one piece therewith. The leg element 59 extends in a right angle with respect to the bottom wall 54 and the side leg 57 to the top. The leg element 59 is angled to an L-shape at the upper end. The second leg element 60 is connected to the first leg element 59 at this L-shaped angled region. The second leg element 60 extends perpendicularly to the first leg element 59 and thus generally parallel to the first and second side legs 56, 57. The second leg element 60 is connected to the first leg element 59 in such a way that an inclined wall surface for receiving the sensor 45 is formed. This inclined wall surface is angled by 45° with respect to the inner walls of the side legs 56, 57.

Even though the leg element 56 is shown in Figure 4 as having a corresponding rotation, the inclined wall surface may also be formed in another way, such as by machining a leg element 60, which is otherwise straightly orientated.

The sensors 45, 46, and 47 are connected to the respective side legs 56, 57 and to the leg element 60 in such a way that they are generally located in one plane. However, the sensors may be mounted in such a way that they are not within one plane.

The sensors 45, 46, 47 are laser distance sensors, which may measure a distance to an object in a corresponding measuring direction 45a, 46a, 47a, such as the distance to a corresponding edge region 39-41 of the holding plate or to a side edge 9 or 10 of a plate 6 of the wafer boat 2. Such sensors detect laser beams reflected from the respective object in a known way, wherein the sensors are preferably perpendicularly directed to the corresponding surface of the object.

The sensors 46, 47 are laterally spaced by a distance corresponding approximately to the width of the corresponding segments of the wafer boat 2 according to Figures 2 and 3 (or corresponding to a width of the bottom edge of the holding plate 38 of the wafer gripper 26). The sensor 45 is inclined according to the inclination of the groove 12 (or according to the inclination of the edge region 39 to the edge regions 41, 42).

Figure 5 shows a schematic perspective view of the measuring system 5 when measuring the spatial position of a wafer gripper 26 of the wafer transport robot. Such a measurement is carried out e.g. during a calibration routine which may be carried out one time prior to a start-up procedure of the wafer transport robot, in order to increase the absolute precision of the wafer transport robot. The calibrating routine may be repeated periodically or after certain events, such as after changing the wafer transport robot, after changing certain components of the wafer transport robot, or after an inadvertent collision, wherein a part of the wafer transport robot collides with an external object. An example of such a calibrating routine is explained in the following.

In the first step, the wafer transport robot 3 is controlled via the control unit in such a way that the control unit moves the wafer gripper 26 to a first position, which corresponds approximately to a theoretical loading position of the wafer boat 2, wherein no wafer boat 2 is present in a loading position at this point in time. In doing so, the control unit or controller specifies a coordinate position stored as a theoretical loading position in the coordinate system of the wafer transport robot, wherein the wafer gripper 26 is to be moved to this coordinate position (usually a center point of the wafer gripper is moved to the position). A theoretical loading position may be e.g. a position in which a perfectly positioned ideal wafer boat 2 would receive a wafer. Since the wafer transport robot 3 is not yet calibrated at this point in time, the wafer transport robot would usually not be able to move the wafer gripper to the exact theoretical loading position (which is a desired position). In this position, the encoder values of the individual rotational joints 32-37 will be sampled and the spatial position of the wafer gripper 26 will be determined automatically by the measuring system 5, as is indicated in Figure 5.

In the first position, the wafer gripper 26 is oriented within the limits of its absolute positioning precision in such a way, with respect to the measuring system 5, that the plane of the holding plate 38 of the wafer gripper 26 is generally perpendicular to the direction of movement of the supporting element 42. Furthermore, the first sensor 45 is oriented generally perpendicular to the edge region 39 of the holding plate 38, while the second and third sensors 46, 47 are oriented generally perpendicular to one of the edge regions 40, 41, at a bottom edge of the holding plate 38 of the wafer gripper 26. During the measuring of the wafer gripper 26, the sensors 45, 46, 47 are moved generally perpendicular to the plane of the holding plate 38 and beyond the holding plate 38 via the drive unit (not shown in detail) for the support element 42. The movement of the drive unit and thus the position of the respective sensors 45, 46, and 47 in the direction of movement is determined via one or more encoders. During movement of the sensors 45, 46, and 47, output signals depending on the encoder values of the sensors 45, 46, and 47 are produced.

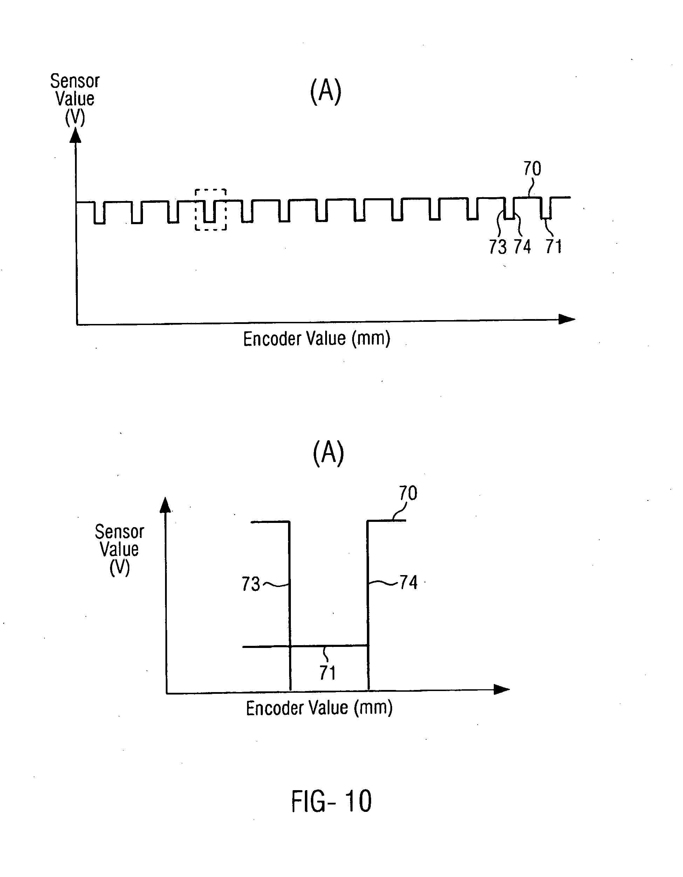

Figure 10A shows an example of an output signal of a sensor depending on an encoder value, wherein the output signal according to Figure 10A has been generated during movement of the sensor across several plates 6 of a wafer boat 2. Such a signal is produced e.g. during determination of the spatial position of the plates 6 of the wafer boat 2, as is explained in more detail in the following. Figure 10B shows an enlarged sub-area of the sensor signal during movement of the sensors across a single plate 6. Such an output signal, according to Figure 10B, would also result from measuring the wafer gripper 26, since only one single plate, i.e. the holding plate 38, would be detected in this case.

The output signals of the sensors 45, 46, and 47 are located on the first (upper) level 70, if no plate is in the field of view of the respective sensor, and the signals are located on the second (lower) level 71, if a plate, such as a plate 6 of the wafer boat 2 or the holding plate 38 of the wafer gripper 26, is located in the field of view of the sensor. The transitions between the first and the second level are formed by the corresponding edges 73, 74 of the sensor signal, wherein the respective edge 73 indicates the entry of the plate 6/holding plate 38 into the field of view of a sensor, when transitioning from the first level 70 to the second level 71, and wherein the edge 74, when transitioning from the second level 71 to the first level 70, indicates exiting of the plate 6/holding plate 38 from the field of view of the sensor. Even though each of the levels 70, 71 and the edges 73, 74 is illustrated in such a way that a perfect rectangular graph is formed, the person skilled in the art will appreciate that the signals will not be as straight as shown in reality. However, mean levels for each of the levels for determining a distance may be calculated. The edge recognition may be achieved e.g. via determining a threshold value.

Based on the height of the second level 71, the distance between the corresponding edge of the plate 6/holding plate 38 and the sensor may be determined. Based on the edges 73, 74 with respect to the corresponding encoder values of the sensors, the position of the edges along the direction of movement of the sensors may be determined. Based on these data of distance to the individual sensors and based on the position data of the individual edges, the spatial position of the plates 6/holding plate 38 may be clearly determined. Especially, the spatial position with respect to the theoretical loading position as a desired position may be determined. In case deviations between the measured spatial position and the desired position are present, as may be expected, at least one adjustment or compensation parameter may be determined for controlling at least one of the rotational joints 32-37 of the wafer transport robot, such that the wafer transport robot positions the wafer gripper closer to the desired position when moving again to the theoretical loading position. During a calibration, the process mentioned above may be repeated one time or several times for the first position, wherein moving the wafer gripper 26 to the first position is carried out, taking into account the at least one compensation parameter during each further pass. The process may be repeated for the first position as long as the wafer transport robot positions the wafer gripper in the desired position within certain tolerances. In this way, the wafer transport robot automatically learns the theoretical loading position.

Thereafter, this process is repeated for further positions, wherein each position corresponds to a respective theoretical loading position. Especially, each of the theoretical loading positions of an ideal wafer boat 2, which is placed in the ideal position (i.e. a wafer boat having perfectly parallel, perfectly spaced, and non-distorted plates 6), may be taught in this way. When moving the wafer gripper 26 in a further position, the previously determined compensation parameters may be taken into account already for the first position, such that the required iteration cycles for reaching a positioning within predetermined tolerances are reduced with progressing calibration.

It should be mentioned that the above process does not need to be carried out for each theoretical loading position, however positioning precision increases with the number of measured positions. In the following, the wafer transport robot thus calibrated may be employed for loading/unloading operations of real wafer boats. Since the wafer boats are usually not perfectly positioned and are usually not of the ideal type, the wafer transport robot must move the wafer gripper to loading positions not corresponding to the measured positions. These positions will be approached via interpolation or via other processes based on the actually measured positions and taking into account the compensation parameters determined during measuring.

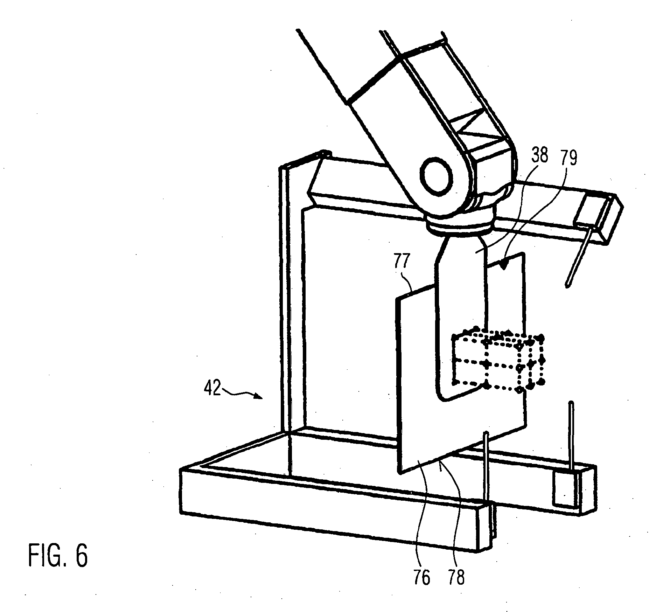

As was discussed above, the measuring system 5 is able to measure the wafer gripper 26 during calibrating of the wafer transport robot 3. During the measuring process, the measuring system directly measured the wafer gripper 26. In order to facilitate direct measuring, the holding plate 38 must have a certain form, which is shown e.g. in Figure 5. However, the measuring system may also determine the spatial position of the wafer gripper indirectly via a plate element fixed to the wafer gripper in known manner, as will be explained in more detail in the following referring to Figure 6.

Figure 6 shows a schematic perspective view of the measuring system 5 when determining the spatial position of an alternative wafer gripper 26. In the following description, the same reference signs as used above will be used for this embodiment as far as the same or equivalent elements are described. The wafer transport robot and the measuring system are constructed in the same way as described above. Only the wafer gripper 26 is different from the wafer gripper described above. Also in this embodiment, the wafer gripper 26 has a holding plate 38 having an integrated vacuum gripper (not shown) for sucking a wafer to the holding plate 38. The holding plate, however, has a generally rectangular form and has dimensions which are smaller than those in the embodiment described above. Therefore, it would not be possible to measure the holding plate 38 directly via the measuring system 5, since not all sensors 45, 46, and 47 would be able to detect an edge of the holding plate during movement along the holding plate 38. Rather, only one sensor or a maximum of two sensors would detect an edge of the holding plate during such a movement, which is not sufficient for acceptably precise determination of the position.

Therefore, the holding plate 38 receives a plate element 76 in a known, defined position for calibrating the wafer transport robot 3, the plate element 76 having known dimensions. Receiving the plate element in a known, defined position may be ensured via e.g. alignment contours (not shown) on the wafer gripper 26 and/or on the plate element 76.

The plate element 76 has a straight top edge 77 as well as a straight bottom edge 78, extending parallel to the top edge. A groove 79 having a known chamfer or inclination is formed in the top edge. The dimensions of the plate element 76 are designed in such a way that the sensors 45, 46, and 47 may each detect a different edge region of the plate element 76 during one single movement of each sensor. Especially, the sensor 45 should be able to detect an edge region in the groove 79, while the sensors 46 and 47 are able to detect spaced edge regions of the bottom edge 78. Especially, the plate element 76 has the dimensions and the form of a segment of a plate 6 of the wafer boat 2.

Because the plate element 76 has a known form and may be received in known, defined manner in the wafer gripper 26, it is possible to determine the spatial position of the wafer gripper 26 via corresponding measurement of the plate element 76 during calibration of the wafer transport robot. To this end, e.g. the same calibration routine as mentioned above may be used.

However, also another calibration routine may be employed. An alternative calibration routine is explained in the following, referring to Figure 6.

First, the wafer transport robot 3 is controlled by the controller unit in such a way that the wafer transport robot 3 moves a predetermined point of the wafer gripper (e.g. the central point thereof) to a first position, which is located within a theoretical loading zone of the wafer boat 2, wherein no wafer boat 2 is present in the loading zone at this point in time. When doing this, the controller specifies a corresponding coordinate position in the coordinate system of the wafer transport robot 3. A region or space in which, when taken into account imprecise positioning of a wafer boat 2, it may be expected that a loading operation may take place, is regarded as a theoretical loading zone. While defined theoretical loading positions had been approached during a fast calibration routine, an arbitrary position within the theoretical loading zone will be approached during the alternative calibration routine. The encoder values of the corresponding rotational joints 32-37 may be detected in this position and may be stored. Afterwards, the spatial location of the wafer gripper 26 is automatically determined in this position by use of the measuring system 5. Especially, the sensors 45, 46, and 47 will be moved along the predetermined movement paths across the plate element 76 on the wafer gripper 26. During this movement, the sensors detect the corresponding edge regions of the plate element. Particularly, the sensor 45 detects or scans an edge region of the groove 79, while the sensors 46 and 47 detect or scan adjacent edge regions at the bottom edge 78. Thus, the spatial position of the wafer gripper 26 may be determined and may be related to the coordinate approached and/or to the encoder values. The wafer gripper may be positioned in the first position in different orientations while maintaining the predetermined point of the wafer gripper. This may be achieved by rotating the wafer gripper about different axes extending through the first position. This is done by correspondingly controlling the rotational joints by use of the robot coordinate system. In the different orientations, the corresponding spatial position of the wafer gripper 26 is automatically determined in the way described above. This process is repeated for a plurality of other positions within the theoretical loading zone. Such different positions are indicated by dots in Figure 6. Each of the approached coordinates and/or each of the encoder values and the correspondingly determined spatial position of the wafer gripper are stored. These data define a space, in which certain control data of the wafer transport robot 3 (coordinates/encoder values) are associated with the correspondingly determined spatial positions of the wafer gripper. Using these data, the wafer transport robot 3 may derive corresponding control data of the wafer transport robot for moving the wafer gripper 26 to a desired loading/unloading position. This may be achieved e.g. by interpolating data between the measured positions, as may be obvious for the person skilled in the art.

In the process above, it is mentioned that the spatial position of the wafer gripper is determined. When doing this, not necessarily the absolute spatial position is determined but only the position with respect to the measuring system. As far as the coordinates of the measuring system are perfectly known, also the absolute spatial position may be derived therefrom, however this is not necessary, as will be explained in the following.

It is to be noted that for loading/unloading the wafer boats 2, the spatial position of the plates 6 and thus of the receptacles for wafers located thereon, is determined in advance by the measuring system 5. From this spatial position, a corresponding loading position may be determined, which needs to be approached by the wafer gripper 26 of the wafer transport robot 3. Since the same measuring system 5 is used for determining the spatial position of the plates 6 as is used for calibrating the wafer transport robot 3, the same reference coordinates (i.e. of the measuring system) are used, and the spatial position of a measured object does not need to be determined absolutely but only with respect to the measuring system.

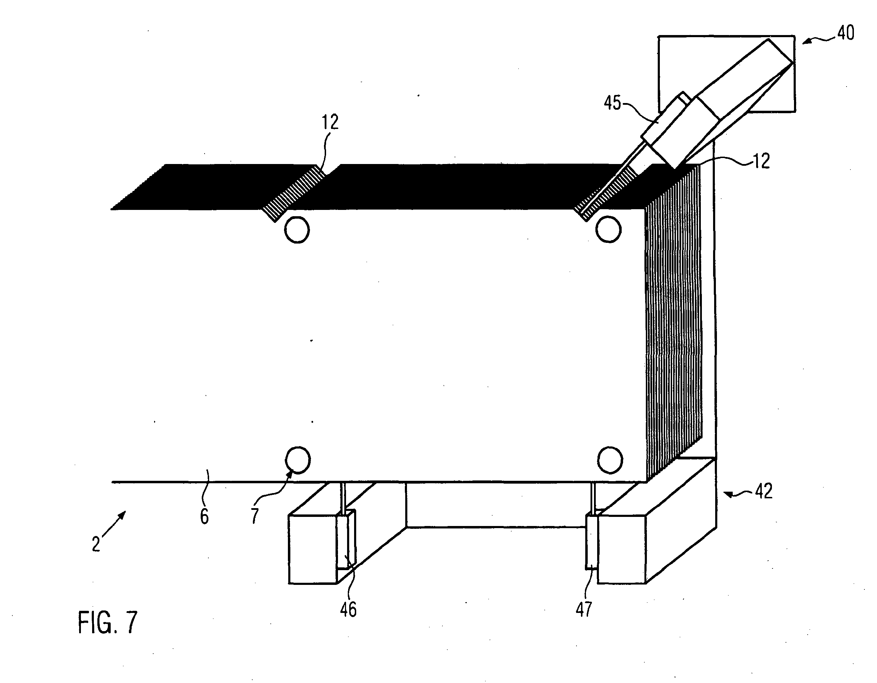

Referring to Figure 7, measuring the wafer boat 2 for loading/unloading is described in the following. Figure 7 shows a schematic perspective view of the measuring system 5 while measuring the wafer boat 2, which is located in a loading/unloading position. Particularly, Figure 7 shows the measuring system in a position, in which a first plate 7 located on the outer surface of the wafer boat 2 is measured in the region of a segment thereof, located on the outer side. The wafer boat 2 is aligned with respect to the measuring system 5 in such a way that the first sensor 45 is directed generally perpendicular to a chamfer or to the inclined part of the groove 12, while the second and third sensors 46, 47 are directed generally perpendicular to a bottom edge of the plates 6. While measuring the corresponding plates 6, the sensors 45, 46, 47 are moved generally perpendicular to the plane of the plates 6 across the plates 6 via the drive unit (not shown in detail) for the support element 42. Movement of the drive unit and thus the position of the corresponding sensors in the direction of movement is determined via one single encoder or a plurality of encoders. During movement of the sensors, output signals of the sensors depending on the encoder value may be yielded, as is illustrated e.g. in figure 10. Figure 10A shows an example of an output signal of a distance sensor as a function of an encoder value during movement of the sensor across several plates 6. Figure 10B shows an enlarged sub-area of the sensor signal during movement of the sensor across a plate 6.

Based on these data, the spatial position of the plates 6 may be determined at least in the region of the correspondingly measured segments A-G. Especially, also the spatial position with respect to a desired position (i.e. a perfectly aligned position from which the theoretical loading positions of the calibrating process described above may be derived) may be determined. Thereafter, this position information will be transmitted to the control unit, wherein the control unit controls the wafer transport robot 3, which had been calibrated as described above, in order to carry out a loading/unloading operation.

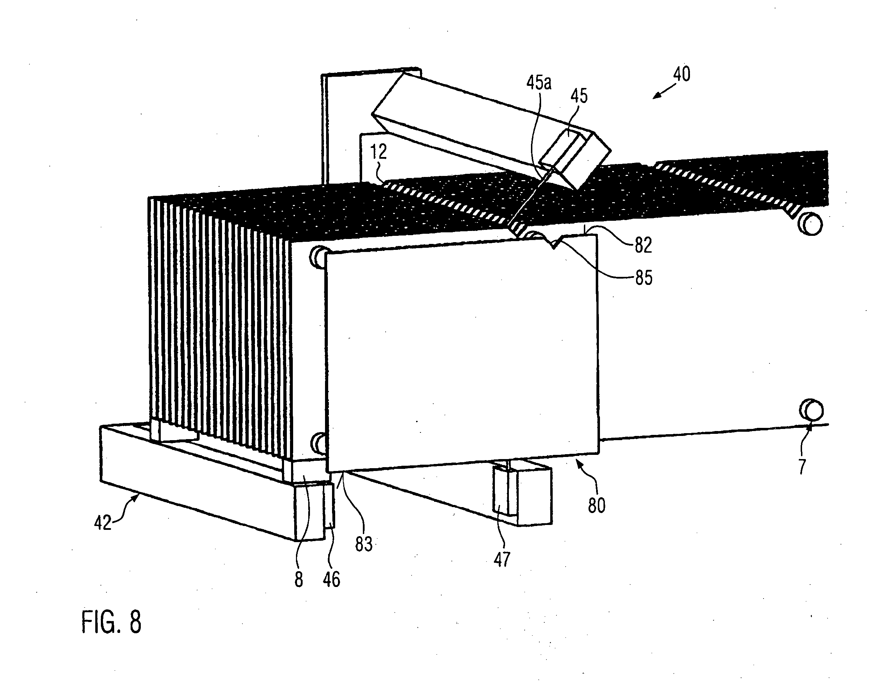

Figure 8 shows a schematic perspective view of an alternative measuring system 5 for determining the spatial position of the plates 6 of a wafer boat 2. The same reference signs as were used above will be used in Figure 8, as far as the same or similar features are described.

Generally, the measuring system 5 has the same construction as was described above. However, the measuring system also comprises an additional element having the form of a reference plate 80, which is maintained in a predetermined position by a device not shown in detail.

The reference plate 80 has a top edge 82 as well as a bottom edge 83 extending parallel to the top edge. The reference plate 80 has a width and a height corresponding to the width and the height of a segment of one plate 6. Of course, it is also possible to form a longer reference plate 80, e.g. corresponding to the length of a whole plate 6. A groove 85, corresponding to the groove 12 in the top edge 9 of the plate 6, is formed in the top edge 82.

Because the reference plate 80 is positioned in a predefined position, it is possible to first measure the reference plate 80 prior to measuring the plates 6 of a wafer boat 2, and thereafter measure the corresponding segments of the plates 6. By this means, the relative position of the individual plates 6 with respect to the reference plate 80 may be determined. By measuring the reference plate 80, also the position of the support 42 as well as the position of the individual sensors 45-47 may be calibrated. It is also possible to determine the precise spatial position of the wafer boat on a carriage supporting or transporting the wafer boat 2 by use of such a reference plate 80. However, particularly e.g. temperature drifts of the sensors 45-47 may be compensated during such a calibration. Of course, the reference plate 80 may also be measured in the same way prior to a corresponding measuring of the wafer gripper 26 when carrying out a calibration of the wafer transport robot 3.

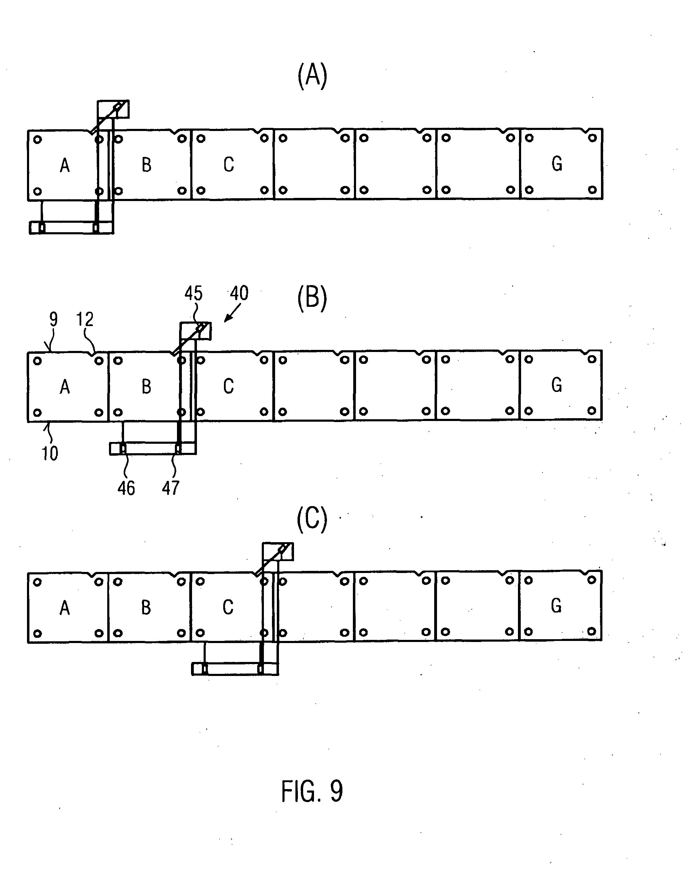

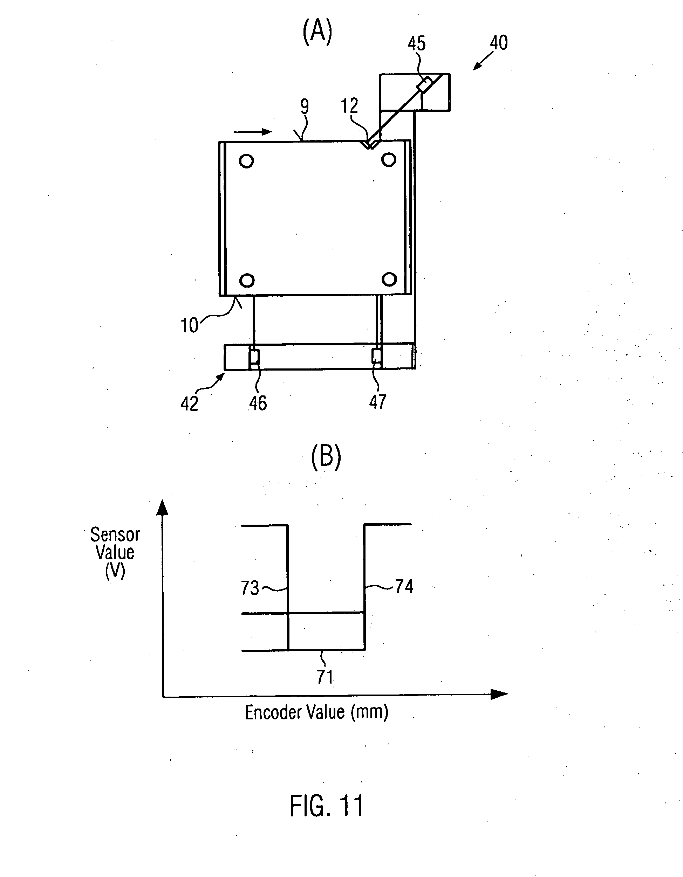

The operation of the measuring system 5 for measuring the spatial position of plates 6 of a wafer boat 2 will be explained in the following, referring to the figures. Particularly, Figures 9A-9C and Figures 11A and 11B will be referred to, these figures showing, on the one hand, schematic front views of the measuring system 5 for measuring different segments A-G of a wafer boat 2 and, on the other hand, a schematic front view of the measuring system while determining the spatial position of a laterally displaced plate segment of a wafer boat as well as an enlarged detailed view of a sensor signal of a sensor.

At first, prior to measuring the spatial position of the plates 6 of a wafer boat 2, a segment A-G of the plates 6 to be measured is aligned with the support element 42. The alignment is carried out in such a way that the sensor 45 moves across the top edge 9 in the region of the groove 12 during movement of the support element, perpendicularly to the plane of the plates 6. The sensors 46, 47 move across the bottom edge 10 of the plates in the region of a segment A-G to be measured during a corresponding movement. According to Figure 9A, initially a segment A of the wafer boat 2 located on the outer left side is measured, while the segment B (Figure 9B) located on the right side adjacent to segment A is measured in a second step, and wherein the segment C located on the right side with respect to the previous segment is measured in a third step (Figure 9C). In this way, all of the 7 segments A-G may be measured one after another. Between measuring of the individual segments, the wafer boat 2 is shifted sideways with respect to the measuring system 5.

As is obvious, the sensor element 45 is located above and laterally with respect to the segment A-G to be measured while measuring a respective segment A-G. By this means, it is possible that the wafer robot 3 has access to a corresponding receptacle slot 15 from above, directly during measuring of the corresponding plates 6, in order to insert a wafer into the group of guiding elements of the plate 6 being measured or in order to remove a wafer therefrom. Thus, it is possible to carry out a loading or unloading operation of the wafers adjacent to the respective plate G, directly following the determination of the spatial position of the corresponding plate 6 in a segment A-G.

Alternatively, it is also possible to first measure a whole segment A-G of the wafer boat 2 and to transmit the information to the wafer robot only thereafter, in order to carry out corresponding loading and unloading operations. However, in a preferred embodiment, the loading and unloading operations are carried out directly following the measuring of the plates 6, since the risk of position variations in the meantime may be reduced substantially in doing so.

During relative movement of the sensors 45, 46, 47 perpendicularly to the plates 6, corresponding sensor values of the corresponding sensors are generated, wherein the spatial position of the corresponding plates 6 may be determined based on these sensor values, especially with respect to an alleged desired position, as was discussed above. Figure 11A shows a segment of a plate 6 which is shifted sideways with respect to a desired position but is otherwise precisely positioned. In this figure, the desired position is schematically shown in a dashed outline.

The sensor signals of the sensors 46, 47 will correspond to the desired sensor signal if the wafer boat is laterally shifted in such a way but is otherwise precisely positioned. Particularly, the edges 73, 74 will occur corresponding to expected encoder values, and the second level 71 will be an expected level.

However, the sensor signal of the sensor 45 will differ from an expected sensor signal. While the edges 73, 74 will appear at the expected point in time, i.e. will occur with respect to the expected encoder values, the second level will be on a different height, since the sensor 45 measures the distance to a different position of the groove 12 instead of the distance to the expected position. By this means, a different distance to the edge of the groove 12 will be determined, which is shown as a different height of the second level 71. This is shown in Figure 11B, wherein the dashed line of the level 71 indicates the expected height, while the solid line indicates the actual level 71. From this difference, a distance variation may be measured, and based on the distance measurement, the lateral shift of the wafer boat 2 may be determined based on the known geometry. The position, determined in such a way, will be transferred to the wafer transport robot 3 thereafter, wherein the wafer transport robot 3 is able to control the wafer gripper 26 so as to load/unload the receiving slots 15. Particularly, loading and/or unloading of a receiving slot 15 adjacent to a plate 6 may be carried out directly after the determination of the position. Thus, loading and/or unloading of the receiving slots 15 may be carried out directly following the corresponding determination of the position of the plates 6, which form the receiving slot 15 in between. However, it is also possible to first measure e.g. all plates 6 within a segment A-G and to provide for loading and/or unloading of the receiving slots 15 in a segmented way thereafter, wherein an adjacent segment A-G may be measured at the same time during loading/unloading.

Figure 11 shows only one example, wherein the spatial position of the plates 6 may be determined with respect to an expected, desired position. A lateral shift of the wafer boat 2, i.e. a shift perpendicular to the plates 6, may be determined e.g. based on the position of the corresponding edges 73, 74 of the sensor signals of the sensors 45, 46, and 47.

A vertical shift of the wafer boat 2 (in the plane of the plate elements) may be determined from distance information, i.e. the height of the second level 71 of the corresponding sensor signals of the sensors 45, 46, and 47. Vertical shifts on one side (i.e. one side of the wafer boat in the longitudinal direction is higher) may also be determined based on distance information of the sensor signals of the sensors 45, 46, and 47.

Diagonal shifts, i.e. lateral to a longitudinal central plane of the wafer boat 2, may be determined based on the edges 73, 74 of the corresponding sensor signal from at least two laterally distance sensors, i.e. the sensors 45 and 46 or the sensors 46 and 47. Of course, also the edge information of all sensors may be used.

A lateral tilt of the wafer boat 2, i.e. a tilt across the width of the wafer boat 2, may be determined e.g. based on the edge information of the corresponding sensors, since the edge information of the upper sensor 45 would indicate a shift to a first direction, while the edge information of the sensors 46 and 47 would show a lateral shift to the other direction. Of course, also more complex and super-imposed shifts may be determined.

In case the apparatus is used in combination with a reference plate, the reference plate may be employed for calibrating the measuring device prior to a corresponding series of measurements.

The apparatus was explained in detail based on preferred embodiments of the invention while referring to the invention, however the apparatus should not be perceived as limited to the specifically described embodiments.

Particularly, the number of plates of the wafer boat and the subdivision in different segments may vary from the shown form. It is also possible to mount the sensors e.g. to a respective individual support element, the support element being movable along a predetermined movement path via corresponding drive units. Also, the wafer transport robot 3 may be constructed differently from the shown wafer transport robot. The wafer transport robot needs to be a type which is adapted to pick up a wafer at a first position and to transport the wafer from the first position to a second position.

## Claims

1. A method for calibrating a wafer transport robot (3) for loading a wafer boat (2) with wafers, wherein the wafer boat (2) comprises a plurality of plates (6) generally arranged parallel to each other in an opposed manner, and wherein the wafer boat (2) comprises a plurality of receptacles for receiving the wafers between adjacent plates (6), and wherein the wafer transport robot (3) comprises a wafer gripper (26) which is adapted to insert a wafer into the receptacles between the plates (6) and to remove a wafer therefrom,
the method being **characterized by** the following steps:
a.) moving the wafer gripper (26) to a first position approximately corresponding to a theoretical loading position of the wafer boat (3);
b.) automatically determining the spacial position of the wafer gripper (26) by
moving at least three sensors (45, 46, 47) along predetermined movement paths across the wafer gripper (26) wherein each of the sensors (45, 46, 47) is directed to an edge region (39, 40 ,41) of the wafer gripper (3) or to an edge region (77, 78, 79) of a plate element (76), which is supported by the wafer gripper (26) in known manner, during the movement,
determining the position of the sensors (45, 46, 47) along the corresponding movement paths and detecting the positions in which a corresponding edge region (39, 40 ,41; 77, 78; 79) enters into and exits from a measuring range of one of the sensors (45, 46, 47),
measuring the distance between each sensor (45, 46, 47) and the corresponding edge region (39, 40 ,41; 77, 78, 79);
c.) determining at least one compensation parameter for positioning the wafer gripper (26) based on a difference between the determined spatial position of the wafer gripper (26) and the theoretical loading position; and
d.) optionally repeating steps a.) to c.) for further theoretical loading positions.

2. The method of claim 1, **characterized in that** the wafer gripper (26) is moved to a new position after determining the at least one compensation parameter wherein the at least one compensation parameter is taken into account, respectively, wherein the new position approximately corresponds to the theoretical loading position of the wafer boat (3), and wherein the spatial position of the wafer gripper (26) is newly determined according to step b.), and wherein at least one new compensation parameter is determined according to step c.), and wherein this method is repeated in case the difference between the determined spatial position of the wafer gripper (26) and the theoretical loading position is outside of the predetermined tolerances.

3. A method for calibrating a wafer transport robot (3) for loading a wafer boat (2) with wafers, wherein the wafer boat (2) comprises a plurality of plates (6) generally arranged parallel to each other in an opposed manner, and wherein the wafer boat (2) comprises a plurality of receptacles for receiving the wafers between adjacent plates (6), and wherein the wafer transport robot (3) comprises a plurality of joints (32 to 37) and a wafer gripper (26) which is adapted to insert a wafer into the receptacles between the plates (6) and to remove a wafer therefrom,
the method being **characterized by** the following steps:
a.) moving a predetermined point of the wafer gripper (26) to a first position within a theoretical loading zone for a wafer boat (2) using a robot coordinate system;
b.) automatically determining the spatial position of the wafer gripper (26) by
moving at least three sensors (45, 46, 47) along predetermined movement paths across the wafer gripper (26), wherein the sensors are directed to an edge region (39, 40 ,41) of the wafer gripper or to the edge region (77, 78, 79) of a plate element (76) being supported by the wafer gripper (26) in known manner during this movement,
determining the position of the sensors (45, 46, 47) along their movement paths and detecting the positions in which each edge region (39, 40 ,41; 77, 78, 79) enters into and exits from the measuring range of one of the sensors (45, 46, 47), measuring the distance between each sensor (45, 46, 47) and the corresponding edge region (39, 40 ,41; 77, 78, 79);
c.) moving the wafer gripper (26) in different orientations using the robot coordinate system, wherein the predetermined point of the wafer gripper stays in the first position, and automatically determining the respective spatial position of the wafer gripper (26) in the different orientations using the steps defined in b.),
d.) moving the predetermined point of the wafer gripper (26) to another position within the theoretical loading zone of the wafer boat (2) using the robot coordinate system and repeating the steps b.) and c.) in the respective positions;
e.) storing the coordinate data of the robot coordinate system corresponding to the positions into which the predetermined point of the wafer gripper (26) was moved and the corresponding determined spatial positions of the wafer gripper (26).

4. A method for loading and/or unloading a wafer boat (2) by means of a wafer transport robot (3), wherein the wafer boat (2) comprises a plurality of plates (6) generally arranged parallel to each other in an opposed manner, and wherein the wafer boat (2) comprises a plurality of receptacles for receiving the wafers between adjacent plates (6), **characterized in that** the wafer transport robot (3) is calibrated according to the method of one of claims 1 to 3,
wherein the spatial position of the plates (6) is determined for each loading or unloading operation by use of the at least three sensors (45, 46, 47) which were used for calibrating the wafer transport robot (3), wherein the spatial position of each of the plates (6) is transmitted to the wafer transport robot (3), and
wherein the wafer transport robot (3) controls the wafer gripper (26) according to the position information in order to load and/or unload the wafer boat (2).

5. The method of claim 4 **characterized in that** the spatial position of the plates (6) is determined by the following steps:
moving the at least three sensors (45, 46, 47) along the predetermined movement path across the plates (6), wherein at least a first movement path is located above the wafer boat (2), wherein at least a second movement path is located below the wafer boat (2), and wherein a third movement path is laterally spaced to the first or second movement paths above or below the wafer boat (2), and wherein the sensors (45, 46, 47) are directed to one respective edge region (9, 10, 12) of the plates (6) during the movement;
continuously determining the position of the sensors (45, 46, 47) along the respective movement paths and detecting the position in which a corresponding edge region (9, 10, 12) of the plates (6) enters into and exits from the measuring range of one of the sensors (45, 46, 47); and measuring the distance between each sensor (45, 46, 47) and the corresponding edge region (9, 10, 12) of the plates (6).

6. The method for calibrating a wafer transport robot or the method for loading and/or unloading a wafer boat of one of the preceding claims **characterized in that** the sensors (45, 46, 47) are initially moved along the predetermined movement paths across at least one reference plate (80) for calibration of the sensors (45, 46, 47) itself, wherein during said movement the position along the respective movement paths is detected in which the sensors (45, 46, 47) detect entering and exiting of respective reference edges (82, 83, 85) of the at least one reference plate (80) into the measuring range and out of the measuring range of the sensors (45, 46, 47), and wherein the distance between each sensor (45, 46, 47) and the corresponding reference edges (82, 83, 85) of the corresponding reference plate (80) are measured.

7. The method for calibrating a wafer transport robot or the method for loading and/or unloading a wafer boat of one of the preceding claims,
**characterized in that** during the movement at least two of the sensors (46, 47) detect edge regions and/or reference edge regions which are parallel to each other and wherein one sensor (45) detects an inclined edge region and/or reference edge region having a known incline with respect to the parallel edge regions and/or reference edge regions.

8. The method for calibrating a wafer transport robot or the method for loading and/or unloading a wafer boat of one of the preceding claims **characterized in that** the sensors (45, 46, 47) are moved by a common drive mechanism.

9. An apparatus (1) for loading and/or unloading a wafer boat (2), which comprises a plurality of plates (6) generally arranged parallel to each other in an opposed manner and which form receiving slots (15) for receiving wafers between adjacent plates, said apparatus (1) comprising:
a wafer transport robot (3) having a wafer gripper (26) and a plurality of arms (28 to 31) and rotational joints (32 to 37) for positioning the wafer gripper (26);
a sensor array having at least three sensors (45, 46, 47), wherein each of the sensors (45, 46, 47) is adapted to measure a distance between the sensor (45, 46, 47) and the edge region (39, 40 ,41; 77, 78, 79; 9,10, 12; 82, 83, 85) of an element (38; 76; 6; 80) entering the measuring range of the sensor (45, 46, 47) along a measuring direction;
at least one support (42) and drive unit for supporting and moving the sensors (45, 46, 47) along predetermined movement paths;
at least one unit for determining the position of the sensors (45, 46, 47) along the corresponding movement paths; and
at least one control unit for controlling the movement of the wafer transport robot (3) and the sensor array, wherein the control unit is configured to control the sensor array during a calibration method as described in any one of claims 1 to 3 in such a way that the control unit is able to determine the spatial position of the wafer gripper (26) in a loading and/or unloading zone, and wherein the control unit controls the movement of the wafer transport robot (3) during loading and/or unloading based on the determined spatial position.

10. The apparatus of claim 9 **characterized in that** the wafer gripper (26) is a plate-shaped wafer gripper.

11. The apparatus of claim 9 or 10 **characterized in that** the control unit is adapted to control the sensor array in such a way that the sensor array determines the spatial position of at least one plate (6) of the wafer boat (2) prior to a corresponding loading and/or unloading operation on the one hand, and wherein the control unit controls the movement of the wafer transport robot (3) based on the determined spatial position of the wafer boat (2) on the other hand.

12. The apparatus of one of claims 9-11 **characterized by** a reference plate (80), which is adjacent to a loading and/or unloading zone for the wafer boat (2) and extends generally perpendicular to the predetermined movement path, wherein the control unit is adapted to move the sensor array across the reference plate (80) prior to determining the spatial position of the wafer gripper (26) and/or the at least one plate (6) of the wafer boat (2), in order to enable a reference measurement for the sensor array.

13. The apparatus of one of claims 9-12 **characterized in that** during movement of the sensor array along the predetermined movement path at least two of the sensors (46, 47) are directed to respective edge regions of the element to be detected, which are arranged parallel to each other, and at least one sensor (45) is directed to an inclined edge region of the element to be detected, said inclined edge region having a known incline with respect to the parallel edge regions.

14. The apparatus of one of the preceding claims **characterized in that** the movement paths of each sensor (45, 46, 47) are arranged generally perpendicular to the element to be detected.

## Patentansprüche

1. Verfahren zum Kalibrieren eines Wafertransportroboters (3) zum Beladen eines Waferbootes (2) mit Wafern, wobei das Waferboot (2) eine Vielzahl von Platten (6) aufweist, die im Wesentlichen parallel zueinander, einander gegenüberliegend, angeordnet sind, und wobei das Waferboot (2) zwischen benachbart zueinander angeordneten Platten (6) eine Vielzahl von Aufnahmen zum Aufnehmen der Wafer aufweist, und wobei der Wafertransportroboter (3) einen Wafergreifer (26) aufweist, der geeignet ist, einen Wafer in die Aufnahmen (15) zwischen den Platten (6) einzusetzen und hieraus zu entnehmen,
wobei das Verfahren **gekennzeichnet ist durch**:
a.) Bewegen des Wafergreifers (26) in eine erste Position, die annähernd einer theoretischen Beladeposition des Waferbootes (2) entspricht;
b.) automatisches Bestimmen der räumlichen Lage des Wafergreifers (26) **durch**
Bewegen von wenigstens drei Sensoren (45, 46, 47) entlang vorbestimmter Bewegungspfade über den Wafergreifer (26) wobei die Sensoren (45, 46, 47) bei der Bewegung jeweils auf einen Kantenbereich (39, 40, 41) des Wafergreifers oder auf einen Kantenbereich (77, 78, 79) eines Plattenelements (76), das in einer bekannten Weise **durch** den Wafergreifer (26) getragen wird, gerichtet werden,
Bestimmen der Positionen der Sensoren (45, 46, 47) entlang ihrer jeweiligen Bewegungspfade und Erfassen der Positionen in welchen ein jeweiliger Kantenbereich (39, 40, 41; 77, 78, 79) in den Messbereich jeweils eines der Sensoren (45, 46, 47) gelangt und aus diesem austritt, und
Messen eines Abstands zwischen einem jeweiligen Sensor (45, 46, 47) und dem jeweiligen Kantenbereich (39, 40, 41; 77, 78, 79);
c.) Bestimmen wenigstens eines Korrekturparameters zum Positionieren des Wafergreifers (26) anhand einer Differenz zwischen der ermittelten räumlichen Lage des Wafergreifers (26) und der theoretischen Beladeposition;
d.) optionales Wiederholen der Schritte a.) bis c.) für weitere theoretische Beladepositionen.

2. Verfahren nach Anspruch 1, **dadurch gekennzeichnet, dass** der Wafergreifer (26) nach dem Ermitteln des wenigstens einen Korrekturparameters jeweils unter Berücksichtigung des wenigstens einen Korrekturparameters in eine neue Position bewegt wird, die annähernd der theoretischen Beladeposition des Waferbootes (2) entspricht und die räumlichen Lage des Wafergreifers (26) gemäß Schritt b.) neu bestimmt und wenigstens ein neuer Korrekturparameter gemäß Schritt c.) ermittelt wird, wobei dieser Vorgang wiederholt wird, falls die Differenz zwischen ermittelter räumlicher Lage des Wafergreifers (26) und theoretischer Beladeposition außerhalb vorbestimmter Toleranzen liegt.

3. Verfahren zum Kalibrieren eines Wafertransportroboters (3) zum Beladen eines Waferbootes (2) mit Wafern, wobei das Waferboot (2) eine Vielzahl von Platten (6) aufweist, die im Wesentlichen parallel zueinander, einander gegenüberliegend, angeordnet sind, und wobei das Waferboot (2) zwischen benachbart zueinander angeordneten Platten (6) eine Vielzahl von Aufnahmen zum Aufnehmen der Wafer aufweist, und wobei der Wafertransportroboter (3) eine Vielzahl von Gelenken (32 bis 37) und einen Wafergreifer (26) aufweist, der geeignet ist, einen Wafer in die Aufnahmen (15) zwischen den Platten (6) einzusetzen und hieraus zu entnehmen,
wobei das Verfahren **gekennzeichnet ist durch**:
a.) Bewegen eines vorbestimmten Punktes des Wafergreifers (26) an eine erste Position innerhalb einer theoretischen Beladezone für ein Waferboot (2) unter Verwendung eines Roboterkoordinatensystems;
b.) automatisches Bestimmen der räumlichen Lage des Wafergreifers (22) **durch**
Bewegen von wenigstens drei Sensoren (45, 46, 47) entlang vorbestimmter Bewegungspfade über den Wafergreifer (26) wobei die Sensoren (45, 46, 47) bei der Bewegung jeweils auf einen Kantenbereich (39, 40, 41) des Wafergreifers oder auf einen Kantenbereich (77, 78, 79) eines Plattenelements (76), das in einer bekannten Weise **durch** den Wafergreifer (26) getragen wird, gerichtet werden,
Bestimmen der Positionen der Sensoren (45, 46, 47) entlang ihrer jeweiligen Bewegungspfade und Erfassen der Positionen in welchen ein jeweiliger Kantenbereich (39, 40, 41; 77, 78, 79) in den Messbereich jeweils eines der Sensoren (45, 46, 47) gelangt und aus diesem austritt, und
Messen eines Abstands zwischen einem jeweiligen Sensor (45, 46, 47) und dem jeweiligen Kantenbereich (39, 40, 41; 77, 78, 79);
c.) Bewegen des Wafergreifers (26) in unterschiedliche Ausrichtungen unter Verwendung des Roboterkoordinatensystems, wobei der vorbestimmte Punkt des Wafergreifers (26) jeweils in der ersten Position beibehalten wird, und
automatisches Bestimmen der jeweiligen räumlichen Lage des Wafergreifers (26) in den unterschiedlichen Ausrichtungen gemäß Schritt b.);
d.) Bewegen des vorbestimmten Punktes des Wafergreifers (26) an eine weitere Position innerhalb des theoretischen Beladebereichs des Waferbootes (2) unter Verwendung des Roboterkoordinatensystems und Wiederholen der Schritte b.) und c.) in den jeweiligen Positionen; und
e.) Speichern der Koordinatendaten des Roboterkoordinatensystems entsprechend den jeweils Punkten zu denen der Wafergreifer (26) bewegt wurde und den entsprechenden räumlichen Lagen des Wafergreifers (26).

4. Verfahren zum Be- und/oder Entladen eines Waferbootes (26) mit einem Wafertransportroboter (3), wobei das Waferboot (2) eine Vielzahl von Platten (6) aufweist, die im Wesentlichen parallel zueinander, einander gegenüberliegend, angeordnet sind, und wobei das Waferboot (2) zwischen benachbart zueinander angeordneten Platten (6) eine Vielzahl von Aufnahmen zum Aufnehmen der Wafer aufweist, **dadurch gekennzeichnet, dass** der Wafertransportroboter nach einem der Ansprüche 1 bis 3 kalibriert ist,
wobei für einen jeweiligen Be- oder Entladevorgang die räumliche Lage der Platten (6) unter Verwendung der wenigstens drei Sensoren (45, 46, 47), die für die Kalibrierung des Wafertransportroboters (3) verwendet wurden, bestimmt wird,
die jeweils ermittelte räumliche Lage der Platten (6) an den Wafertransportroboter (3) übermittelt wird, und
der Wafertransportroboter (3) seinen Wafergreifer (26) entsprechend der Lageinformation steuert, um das Waferboot (2) zu be- und/oder entladen.

5. Verfahren nach Anspruch 4, **dadurch gekennzeichnet, dass** die räumliche Lage der Platten (6) durch die folgenden Schritte bestimmt wird:
Bewegen der wenigstens drei Sensoren (45, 46, 47) entlang der vorbestimmten Bewegungspfade, wobei wenigstens ein erster Bewegungspfad oberhalb des Waferbootes (2), wenigstens ein zweiter Bewegungspfad unterhalb des Waferbootes (2) und ein dritter Bewegungspfad seitlich beabstandet zu dem ersten oder zweiten Bewegungspfad ober- oder unterhalb des Waferbootes (2) liegt, und wobei die Sensoren (45, 46, 47) bei der Bewegung jeweils auf einen Kantenbereich (9, 10, 12) der Platten (6) gerichtet werden;
kontinuierliches Bestimmen der Position der Sensoren (45, 46, 47) entlang des jeweiligen Bewegungspfads und Erfassen der Position in welcher ein jeweiliger Kantenbereich (9, 10, 12) der Platten (6) in den Messbereich eines der Sensoren (45, 46, 47) gelangt und aus diesem austritt; und
Messen des Abstands zwischen einem jeweiligen Sensor (45, 46, 47) und dem jeweiligen Kantenbereich (9, 10, 12) der Platten (6).

6. Verfahren zum Kalibrieren eines Wafertransportroboters oder Verfahren zum Be- und/oder Entladen eines Waferbootes nach einem der vorhergehenden Ansprüche, **dadurch gekennzeichnet, dass** die Sensoren (45, 46, 47) für eine Kalibrierung der Sensoren (45, 46, 47) zunächst entlang der vorbestimmten Bewegungspfade über wenigstens eine Referenzplatte (80) bewegt werden,
wobei während der Bewegung erfasst wird, in welcher Position die Sensoren (45, 46, 47) entlang des jeweiligen Bewegungspfads den Eintritt und den Austritt jeweiliger Referenzkanten (82, 83, 85) der wenigstens einen Referenzplatte (80) in den Messbereich der Sensoren (45, 46, 47) detektieren und wobei der Abstand zwischen jedem Sensor (45, 46, 47) und der jeweiligen Referenzkanten (82, 83, 85) der Referenzplatte (80) gemessen wird.

7. Verfahren zum Kalibrieren eines Wafertransportroboters oder Verfahren zum Be- und/oder Entladen eines Waferbootes nach einem der vorhergehenden Ansprüche, **dadurch gekennzeichnet, dass** wenigstens zwei der Sensoren (46, 47) bei der Bewegung jeweils parallel zueinander angeordnete Kantenbereiche und/oder Referenzkantenbereiche erfassen und wenigstens ein Sensor (45) einen schrägen Kantenbereich und/oder Referenzkantenbereich, der eine bekannte Schräge bezüglich der Kantenbereiche und/oder Referenzkantenbereiche besitzt, erfassen.

8. Verfahren zum Kalibrieren eines Wafertransportroboters oder Verfahren zum Be- und/oder Entladen eines Waferbootes nach einem der vorhergehenden Ansprüche, **dadurch gekennzeichnet, dass** die Sensoren (45, 46, 47) über einen gemeinsamen Bewegungsmechanismus bewegt werden.

9. Vorrichtung (1) zum Be- und /oder Entladen eines Waferbootes (2), das eine Vielzahl von Platten (6) aufweist, die im Wesentlichen parallel zueinander, einander gegenüberliegend angeordnet sind und zwischen benachbarten Platten (6) Aufnahmeschlitze (15) zur Aufnahme von Wafern bilden, wobei die Vorrichtung (1) folgendes aufweist:
einen Wafertransportroboter (3) mit einem Wafergreifer (26) und einer Vielzahl von Armen (28 bis 31) und Drehgelenken (32 bis 37) zum Positionieren des Wafergreifers (26);
eine Sensoranordnung mit wenigstens drei Sensoren (45, 46, 47), wobei jeder der Sensoren (45, 46, 47) geeignet ist entlang einer Messrichtung einen Abstand zwischen dem Sensor (45, 46, 47) und einem Kantenbereich (9, 10, 12; 39, 40, 41; 77, 78, 79; 9, 10, 12; 82, 83, 85) eines in den Messbereich des Sensors (45, 46, 47) gelangenden Elements (38; 76; 6; 80) zu messen;
wenigstens eine Trag- und Bewegungseinheit (42) zum Tragen und Bewegen der Sensoren (45, 46, 47) entlang vorbestimmter, bekannter Bewegungspfade;
wenigstens eine Einheit zum Bestimmen der Position der Sensoren (45, 46, 47) entlang der jeweiligen Bewegungspfade; und
wenigstens eine Steuervorrichtung zum Steuern der Bewegung des Wafertransportroboters (3) und der Sensoranordnung, wobei die Steuervorrichtung konfiguriert ist, die Sensoranordnung im Rahmen einer Kalibrierung nach einem der Ansprüche 1 bis 2 oder 3 so zu steuern,
dass sie die räumliche Lage des Wafergreifers (26) innerhalb einer Be- und/oder Entladezone des Waferbootes (2) ermitteln kann, und die Bewegung des Wafertransportroboters (3) bei einer Be- und/oder Entladung aufgrund der ermittelten räumlichen Lage zu steuern.

10. Vorrichtung nach Anspruch 9, **dadurch gekennzeichnet, dass** der Wafergreifer (26) ein plattenförmiger Wafergreifer ist.

11. Vorrichtung nach Anspruch 9 oder 10, **dadurch gekennzeichnet, dass** die Steuervorrichtung geeignet ist,
einerseits die Sensoranordnung so zu steuern, dass sie vor einem jeweiligen Be- und/oder Entladungsvorgang die räumliche Lage einer Platte (6) des Waferbootes (2) ermittelt, und
andererseits die Bewegung des Wafertransportroboters (3) anhand der ermittelten räumlichen Lage des Waferbootes (2) zu steuern.

12. Vorrichtung nach einem der Ansprüche 9 bis 11, **gekennzeichnet durch** eine Referenzplatte (80), die benachbart zu einem Be- und/oder Entladebereich für das Waferboot (2) angeordnet ist und sich im wesentlichen senkrecht zu den vorbestimmten Bewegungspfaden erstreckt, wobei die Steuervorrichtung geeignet ist, die Sensoranordnung vor der Bestimmung der räumlichen Lage des Wafergreifers (26) und/oder der wenigstens einen Platte (6) des Waferbootes (2) an der Referenzplatte (80) vorbeizubewegen, um eine Referenzmessung für die Sensoren (45, 46, 47) der Sensoranordnung zu ermöglichen.

13. Vorrichtung nach einem der Ansprüche 9 bis 12, **dadurch gekennzeichnet, dass** während der Bewegung entlang des vorbestimmten Bewegungspfades wenigstens zwei der Sensoren (46, 47) auf jeweilige Kantenbereich des zu detektierenden Elements gerichtet sind, die parallel zueinander sind, und dass wenigstens ein Sensor (45) auf einen schrägen Kantenbereich des zu detektierenden Elements gerichtet ist, wobei der schräge Kantenbereich eine bekannte Schräge bezüglich der parallelen Kantenbereiche besitzt.

14. Vorrichtung nach einem der vorhergehenden Ansprüche, **dadurch gekennzeichnet, dass** die Bewegungspfade des Sensors (45, 46, 47) im Wesentlichen senkrecht zu einem zu detektierenden Element angeordnet sind.

## Revendications

1. Procédé pour étalonner un robot de transport de tranches (3) pour charger une nacelle de tranches (2) avec des tranches, dans lequel la nacelle de tranches (2) comprend une pluralité de plaques (6) agencées de façon générale parallèles entre elles et opposées, et dans lequel la nacelle de tranches (2) comprend une pluralité de réceptacles pour recevoir les tranches entre des plaques adjacentes (6), et dans lequel le robot de transport de tranches (3) comprend un dispositif de saisie de tranche (26) qui est à adapté à insérer une tranche dans les réceptacles entre les plaques (6) et à en retirer une tranche,
le procédé étant **caractérisé en ce qu'**il comprend les étapes suivantes :
a.) déplacer le dispositif de saisie de tranches (26) vers une première position correspondant approximativement à une position de chargement théorique de la nacelle de tranches (3) ;
b.) déterminer automatiquement la position spatiale du dispositif de saisie de tranche (26)
en déplaçant au moins trois capteurs (45, 46, 47) le long de chemins de mouvement prédéterminés à travers le dispositif de saisie de tranche (26), chacun des capteurs (45, 46, 47) étant dirigé vers une région de bord (39, 40, 41) du dispositif de saisie de tranche (3) ou vers une région de bord (77, 78, 79) d'un élément en forme de plaque (76), qui est supporté par le dispositif de saisie de tranche (26) de manière connue, pendant le mouvement,
en déterminant la position des capteurs (45, 46, 47) le long des chemins de mouvement correspondants et en détectant les positions dans lesquelles une région de bord correspondante (39, 40, 41 ; 77, 78, 79) rentre et sort d'une plage de mesure de l'un des capteurs (45, 46, 47),
en mesurant la distance entre chaque capteur (45, 46, 47) et la région de bord correspondante (39, 40, 41 ; 77, 78, 79) ;
c.) déterminer au moins un paramètre de compensation pour positionner le dispositif de saisie de tranches (26) sur la base d'une différence entre la position spatiale déterminée du dispositif de saisie de tranches (26) et la position de chargement théorique ; et
d.) répéter de façon optionnelle les étapes a.) à c.) pour d'autres positions de chargement théoriques.

2. Procédé selon la revendication 1, **caractérisé en ce que** le dispositif de saisie de tranche (26) est déplacé vers une nouvelle position après avoir déterminé ledit au moins un paramètre de compensation, dans lequel ledit au moins un paramètre de compensation est pris en compte, respectivement, dans lequel la nouvelle position correspond approximativement à la position de chargement théorique de la nacelle de tranches (3), et dans lequel la position spatiale du dispositif de saisie de tranche (26) est nouvellement déterminée selon l'étape b.), et dans lequel au moins un nouveau paramètre de compensation est déterminé conformément à l'étape c.), et dans lequel ce procédé est répété dans le cas où la différence entre la position spatiale déterminée du dispositif de saisie de tranche (26) et la position de chargement théorique est en dehors des tolérances prédéterminées.

3. Procédé pour étalonner un robot de transport de tranches (3) pour charger une nacelle de tranches (2) avec des tranches, dans lequel la nacelle de tranches (2) comprend une pluralité de plaques (6) agencées de façon générale parallèles entre elles et opposées, et dans lequel la nacelle de tranches (2) comprend une pluralité de réceptacles pour recevoir les tranches entre des plaques adjacentes (6), et dans lequel le robot de transport de tranches (3) comprend une pluralité d'articulations (32 à 37) et un dispositif de saisie de tranche (26) qui est adapté à insérer une tranche dans les réceptacles entre les plaques (6) et à en retirer une tranche, le procédé étant **caractérisé en ce qu'**il comprend les étapes suivantes :
a.) déplacer un point prédéterminé du dispositif de saisie de tranche (26) vers une première position dans une zone de chargement théorique pour une nacelle de tranches (2) en utilisant un système de coordonnées de robot ;
b.) déterminer automatiquement la position spatiale du dispositif de saisie de tranches (26)
en déplaçant au moins trois capteurs (45, 46, 47) le long de chemins de mouvement prédéterminés à travers le dispositif de saisie de tranches (26), dans lequel les capteurs sont dirigés vers une région de bord (39, 40, 41) du dispositif de saisie de tranche ou vers la région de bord (77, 78, 79) d'un élément en forme de plaque (76) supporté par le dispositif de saisie de tranches (26) de façon connue pendant ce mouvement,
en déterminant la position des capteurs (45, 46, 47) le long de leurs chemins de mouvement et en détectant les positions dans lesquelles chaque région de bord (39, 40, 41 ; 77, 78, 79) rentre dans et sort de la plage de mesure de l'un des capteurs (45, 46, 47),
en mesurant la distance entre chaque capteur (45, 46, 47) et la région de bord correspondante (39, 40, 41 ; 77, 78, 79) ;
c.) déplacer le dispositif de saisie de tranche (26) dans différentes orientations en utilisant le système de coordonnées de robot, le point prédéterminé du dispositif de saisie de tranche restant dans la première position, et déterminer automatiquement la position spatiale respective du dispositif de saisie de tranche (26) dans les différentes orientations en utilisant les étapes définies dans b.),
d.) déplacer le point prédéterminé du dispositif de saisie de tranche (26) vers une autre position dans la zone de chargement théorique de la nacelle de tranches (2) en utilisant le système de coordonnées de robot et en répétant les étapes b.) et c.) dans les positions respectives ;
e.) mémoriser les données de coordonnées du système de coordonnées de robot correspondant aux positions dans lesquelles le point prédéterminé du dispositif de saisie de tranche (26) a été déplacé et les positions spatiales déterminées correspondantes du dispositif de saisie de tranche (26).

4. Procédé pour charger et/ou décharger une nacelle de tranches (2) au moyen d'un robot de transport de tranches (3), dans lequel la nacelle de tranches (2) comprend une pluralité de plaques (6) agencées de façon générale parallèles entre elles et opposées, et dans lequel la nacelle de tranches (2) comprend une pluralité de réceptacles pour recevoir les tranches entre des plaques adjacentes (6), **caractérisé en ce que** le robot de transport de tranches (3) est étalonné selon le procédé de l'une quelconque des revendications 1 à 3,
dans lequel la position spatiale des plaques (6) est déterminée pour chaque opération de chargement et de déchargement en utilisant lesdits au moins trois capteurs (45, 46, 47) qui ont été utilisés pour étalonner le robot de transport de tranches (3), les positions spatiales de chacune des plaques (6) étant transmises au robot de transport de tranches (3), et
dans lequel le robot de transport de tranches (3) contrôle le dispositif de saisie de tranche (26) en fonction des informations de position afin de charger et/ou décharger la nacelle de tranches (2).

5. Procédé selon revendication 4, **caractérisé en ce que** la position spatiale des plaques (6) est déterminée par les étapes suivantes :
déplacer lesdits au moins trois capteurs (45, 46, 47) le long du chemin de mouvement prédéterminé à travers les plaques (6), dans lequel au moins un premier chemin de mouvement est situé au-dessus de la nacelle de tranches (2), dans lequel au moins un deuxième chemin de mouvement est situé en dessous de la nacelle de tranches (2), et dans lequel un troisième chemin de mouvement est espacé latéralement des premier et deuxième chemins de mouvement au-dessus ou en dessous de la nacelle de tranches (2), et dans lequel les capteurs (45, 46, 47) sont dirigés vers une région de bord respective (9, 10, 12) des plaques (6) pendant le mouvement ;
déterminer de façon continue la position des capteurs (45, 46, 47) le long des chemins de mouvement respectifs et détecter la position dans laquelle une région de bord correspondante (9, 10, 12) des plaques (6) entre dans et sort de la plage de mesure de l'un des capteurs (45, 46, 47) ; et
mesurer la distance entre chaque capteur (45, 46, 47) et la région de bord correspondante (9, 10, 12) des plaques (6).

6. Procédé pour étalonner un robot de transport de plaques ou procédé pour charger et/ou décharger une nacelle de tranches selon l'une quelconque des revendications précédentes, **caractérisé en ce que** les capteurs (45, 46, 47) sont déplacés initialement le long des chemins de mouvement prédéterminés à travers au moins une plaque de référence (80) pour étalonner les capteurs (45, 46, 47) eux-mêmes, dans lequel pendant le mouvement la position le long des chemins de mouvements respectifs est détectée, dans lequel les capteurs (45, 46, 47) détectent l'entrée et la sortie de bords de référence respectifs (82, 83, 85) de ladite au moins une plaque de référence (80) dans la plage de mesure et en dehors de la plage de mesure des capteurs (45, 46, 47), et dans lequel les distances entre chaque capteur (45, 46, 47) et les bords de référence correspondants (82, 83, 85) de la plaque de référence correspondante (80) sont mesurés.

7. Procédé pour étalonner un robot de transport de tranches ou procédé pour charger et/ou décharger une nacelle de tranches de l'une des revendications précédentes, **caractérisé en ce que** pendant le mouvement, au moins deux des capteurs (46, 47) détectent des régions de bord et/ou des régions de bord de référence qui sont parallèles entre elles, et dans lequel l'un des capteurs (45) détecte une région de bord inclinée et/ou une région de bord de référence ayant une inclinaison connue par rapport aux régions de bord parallèles et/ou aux régions de bord de référence.

8. Procédé pour étalonner un robot de transport de tranches ou procédé pour charger et/ou décharger une nacelle de tranches selon l'une quelconque des revendications précédentes, **caractérisé en ce que** les capteurs (45, 46, 47) sont déplacés par un mécanisme d'entraînement commun.

9. Appareil (1) pour charger et/ou décharger une nacelle de tranches (2), qui comprend une pluralité de plaques (6) agencées de façon générale parallèles entre elles et opposée et qui forment des fentes de réception (15) pour recevoir des tranches entre des plaques adjacentes, l'appareil (1) comprenant :
un robot de transport de tranches (3) comportant un dispositif de saisie de tranche (26) et une pluralité de bras (28 à 31) et des articulations (32 à 37) pour positionner le dispositif de saisie de tranche (26) ;
un réseau de capteurs comportant au moins trois capteurs (45, 46, 47), dans lequel chacun des capteurs (45, 46, 47) est adapté à mesurer une distance entre le capteur (45, 46, 47) et la région de bord (39, 40, 41 ; 77, 78, 79 ; 9, 10, 12 ; 82, 83, 85) d'un élément (38 ; 76 ; 6 ; 80) rentrant dans la plage de mesure du capteur (45, 46, 47) le long d'une direction de mesure ;
au moins un support (42) et un module d'entraînement pour supporter et déplacer les capteurs (45, 46, 47) le long de chemins de mouvement prédéterminés ;
au moins un module pour déterminer la position des capteurs (45, 46, 47) le long des chemins de mouvement correspondants ; et
au moins un module de commande pour contrôler le mouvement du robot de transport de tranches (3) et du réseau de capteurs, dans lequel le module de commande est agencé pour contrôler le réseau de capteurs pendant un procédé de d'étalonnage tel que décrit dans l'une quelconque des revendications 1 à 3, de sorte que le module de commande est capable de déterminer la position spatiale du dispositif de saisie de tranche (26) dans une zone de chargement et/ou déchargement, et dans lequel le module de commande contrôle le mouvement du robot de transport de tranches (3) pendant le chargement et/le déchargement sur la base de la position spatiale déterminée.

10. Appareil selon la revendication 9, **caractérisé en ce que** le dispositif de saisie de tranche (26) est un dispositif de saisie de tranche en forme de plaque.

11. Appareil selon la revendication 9 ou 10, **caractérisé en ce que** le module de commande est adapté, d'une part, à contrôler le réseau de capteurs de telle sorte que le réseau de capteurs détermine la position spatiale d'au moins une plaque (6) de la nacelle de tranches (2) avant une opération de chargement et/ou de déchargement correspondante, et dans lequel le module de commande contrôle, d'autre part, le mouvement du robot de transport de tranches (3) sur la base de la position spatiale déterminée de la nacelle de tranches (2).

12. Appareil selon l'une quelconque des revendications 9 à 11, **caractérisé par** une plaque de référence (80), qui est adjacente à une zone de chargement et/ou de déchargement pour la nacelle de tranches (2) et s'étend de façon générale perpendiculairement au chemin de mouvement prédéterminé, dans lequel le module de commande est adapté à déplacer le réseau de capteurs à travers la plaque de référence (80) avant de déterminer la position spatiale du dispositif de saisie de tranche (26) et/ou de ladite au moins une plaque (6) de la nacelle de tranches (2), afin de permettre une mesure de référence pour le réseau de capteurs.

13. Appareil selon l'une quelconque des revendications 9 à 12, **caractérisé en ce que** pendant le mouvement du réseau de capteurs le long du chemin de mouvement prédéterminé, au moins deux des capteurs (46, 47) sont dirigés vers des régions de bord respectives de l'élément à détecter, qui sont disposées parallèles entre elles, et au moins un capteur (45) est dirigé vers une région de bord inclinée de l'élément à détecter, la région de bord inclinée ayant une inclinaison connue par rapport aux régions de bord parallèles.

14. Appareil selon l'une quelconque des revendications précédentes, **caractérisé en ce que** les chemins de mouvement de chaque capteur (45, 46, 47) sont agencés de façon générale perpendiculairement à l'élément à détecter.
